# EUROPEAN PATENT SPECIFICATION

(11) **EP 3 340 221 B1**
(45) Date of publication and mention of the grant of the patent: **08.04.2020**
(21) Application number: 17206937.9
(22) Date of filing: 13.12.2017
(51) Int. Cl.: G09G 3/3225, G09G 3/20, G09G 3/3275

(54) **ORGANIC LIGHT-EMITTING DISPLAY DEVICE AND METHOD OF DRIVING THE SAME**
ANZEIGEVORRICHTUNG MIT ORGANISCHEN LEUCHTDIODEN UND VERFAHREN ZUR ANSTEUERUNG DAVON
DISPOSITIF D'AFFICHAGE ÉLECTROLUMINESCENT ORGANIQUE ET SON PROCÉDÉ DE COMMANDE

(30) Priority: 26.12.2016 KR 20160179452
(43) Date of publication of application: 27.06.2018
(73) Proprietor: LG Display Co., Ltd., Seoul 07336 (KR)
(72) Inventor: LEE, Joonhee, 10845 Gyeonggi-do (KR); KIM, Janghwan, 10845 Gyeonggi-do (KR); PARK, Dongwon, 10845 Gyeonggi-do (KR); PARK, Jongmin, 10845 Gyeonggi-do (KR); KWON, Yongchul, 10845 Gyeonggi-do (KR)
(74) Representative: Morrall, Jonathan Ian McLachlan

(56) References cited:
- KR-A- 20120 110 257
- US-A1- 2014 340 379
- US-A1- 2016 293 101
- US-A1- 2017 193 900

## Description

### BACKGROUND OF THE INVENTION

### Field of the Invention

The present disclosure relates to an organic light-emitting display device and a method of driving the same.

### Discussion of the Related Art

Along with evolving information technology, display devices have been widely used as a connection medium between a user and information. In this regard, as one type of display device, an organic light-emitting display device has been increasingly employed.

The organic light-emitting display device may include a display panel including a plurality of sub-pixels, a driver to output a drive signal to drive the display panel, and a power supply to generate power to be supplied to the driver and display panel. The driver may include a scan driver to supply a scan signal or a gate signal to the display panel, and a data driver to supply a data signal to the display panel.

When the sub-pixels in the display panel receive drive signals, for example, the scan signal and the data signal, a selected sub-pixel emits a light beam. In this manner, the sub-pixels may display an image.

The organic light-emitting display device may be implemented in a variety of devices, such as a television, a navigation device, a video player, a personal computer, wearable devices including, for example, a watch and glasses, and mobile phones including, for example, a smartphone. There is a need to reduce power consumption in conventional organic light-emitting display devices.

US 2016/0293101 A1 describes a method of driving a display device which includes calculating an average load and an asymmetry by analyzing an input image data, and adjusting at least one of a high data voltage and a low data voltage, which are supplied to a display panel of the display device, based on the average load and the asymmetry.

KR 2012 0110257 A describes an apparatus and method for driving an organic electroluminescent display panel, wherein if an input code less than a determined threshold value is inputted, a digital control mode is used, and if an input code more than the determined threshold value is inputted, an analog control mode is used.

### SUMMARY OF THE INVENTION

In one aspect, there is provided an organic light-emitting display device including a display panel, a power supply, a selective driver and a gamma change driver according to claims 1-10.

In another aspect, there is provided a method of driving an organic light-emitting display device according to claims 11-14.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.
FIG. 1 is a schematic block view of an organic light-emitting display device in accordance with a first embodiment of the present invention.
FIG. 2 schematically illustrates a configuration of a sub-pixel in FIG. 1.
FIG. 3 illustrates a circuit configuration of a related art sub-pixel.
FIG. 4 is a graph of a current versus voltage curve of a drive transistor based on a related art driving scheme.
FIG. 5 illustrates a circuit configuration of a sub-pixel in accordance with a first embodiment of the present invention.
FIG. 6 is a graph of current versus voltage curves of a drive transistor in accordance with a first embodiment of the present invention.
FIG. 7 is a graph of a gamma voltage versus gray-scale curve for describing a gray-scale expression scheme in accordance with a first embodiment of the present invention.
FIG. 8 is a graph of a luminance versus gray-scale curve based on a gray-scale expression scheme in FIG. 7.
FIG. 9 is a graph of an adaptive gamma curve for gray-scale expression in accordance with a first embodiment of the present invention.
FIG. 10 illustrates an exemplary configuration of a device in accordance with a first embodiment of the present invention.
FIG. 11 is a graph of current versus voltage curves of a drive transistor for describing a driving method of an organic light-emitting display device in accordance with a first embodiment of the present invention.
FIG. 12 shows a block diagram of components of interest of an organic light-emitting display device in accordance with a first embodiment of the present invention.
FIG. 13 shows a modular configuration in accordance with a first example of the present invention.
FIG. 14 shows a modular configuration in accordance with a second example of the present invention.
FIG. 15 is a schematic block view of an organic light-emitting display device in accordance with a second embodiment of the present invention.
FIG. 16 schematically illustrates a configuration of a sub-pixel in FIG. 15.
FIG. 17 illustrates a circuit configuration of a sub-pixel in accordance with a second embodiment of the present invention.
FIG. 18 is a graph of current versus voltage curves of a drive transistor in accordance with a second embodiment of the present invention.
FIG. 19 is a graph of a voltage versus gray-scale curve of a drive transistor for describing a driving method of an organic light-emitting display device in accordance with a second embodiment of the present invention.
FIG. 20 describes a problem of deterioration of a drive transistor.
FIG. 21 is a graph of current versus voltage curves for a drive transistor for describing a high level voltage changing scheme in accordance with a second embodiment of the present invention.
FIG. 22 shows a modular configuration in accordance with a third example of the present invention.
FIG. 23 shows a modular configuration in accordance with a fourth example of the present invention.
FIG. 24 is a schematic block view of an organic light-emitting display device in accordance with a third embodiment of the present invention.
FIG. 25 schematically illustrates a configuration of a sub-pixel in FIG. 24.
FIGS. 26 and 27 are diagrams for describing a comparison between a scheme of changing a level of a high level voltage and a scheme of changing a level of a low level voltage in order to drive a drive transistor in a linear region and generate a target current.
FIG. 28 is a graph of current versus voltage curves of a drive transistor for describing a driving method of an organic light-emitting display device in accordance with a third embodiment of the present invention.
FIGS. 29 and 30 are views illustrating examples of changing a low level voltage in accordance with a third embodiment of the present invention.
FIG. 31 is a view for explaining a method for determining whether an image quality problem has occurred when driving a drive transistor in a linear region.
FIG.32 is a flowchart for explaining a selection scheme of linear driving and saturation driving in accordance with a third embodiment of the present invention.
FIG. 33 shows a modular configuration in accordance with a fifth example of the present invention.
FIG. 34 shows a modular configuration in accordance with a sixth example of the present invention.

### DETAILED DESCRIPTION OF THE EMBODIMENTS

Reference will now be made in detail embodiments of the invention examples of which are illustrated in the accompanying drawings.

Hereinafter, detailed embodiments of the invention will be described with reference to the accompanying drawings.

An organic light-emitting display device may be implemented, for example, as a top-emission, bottom-emission, or dual-emission type, depending on a light-emission direction therefrom.

The organic light-emitting display device may also be implemented, for example, as an inverted staggered, staggered, or coplanar type, depending on a channel structure of a transistor employed. The inverted staggered type may include a back channel etched (BCE) type or an etch stopper (ES) type.

The organic light-emitting display device may further be implemented, for example, as an oxide, low temperature poly-silicon (LTPS), amorphous silicon (a-Si), or poly-silicon (p-Si) type, depending on a semiconductor material of a transistor.

The organic light-emitting display device may be implemented, for example, in a television, a navigation device, a video player, a personal computer, wearable devices, such as watches and glasses, and mobile phones, such as a smartphone.

### <A first embodiment >

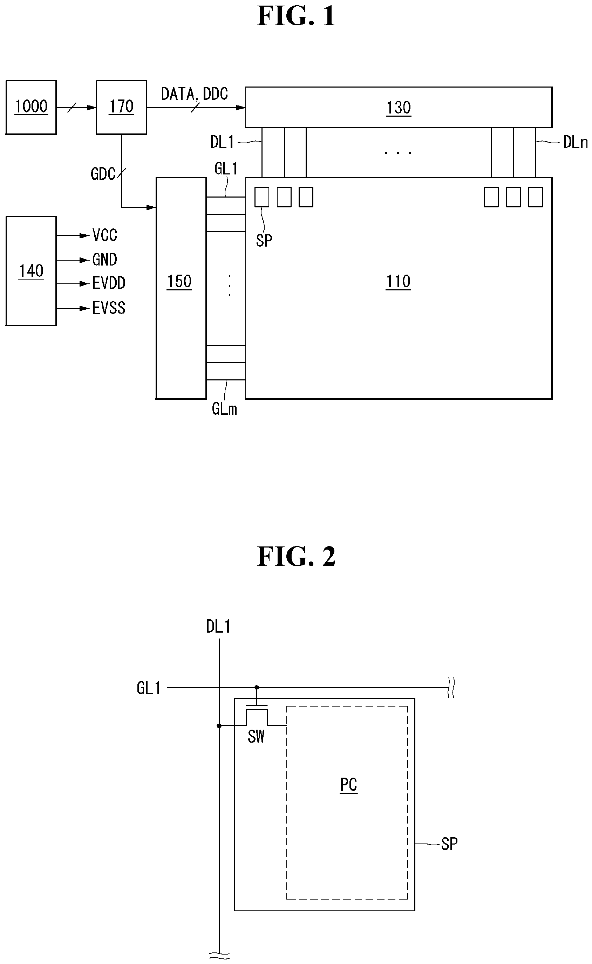

FIG. 1 is a schematic block view of an organic light-emitting display device in accordance with a first embodiment of the present invention. FIG. 2 schematically illustrates a configuration of a sub-pixel in FIG. 1.

As shown in FIG. 1, the organic light-emitting display device may include a host system 1000, a timing controller 170, a data driver 130, a power supply 140, a gate driver 150, and a display panel 110.

The host system 1000 may include a SoC (System on Chip) having a scaler disposed therein. The host system 1000 may convert digital video data of an input video to a data signal with a suitable format for display on the display panel 110 and then output the data signal. The host system 1000 may also supply a variety of timing signals along with the data signal to the timing controller 170.

The timing controller 170 may be configured to control operation timings of the data driver 130 and the gate driver 150 based on the timing signals from the host system 1000. Examples of the timing signals include vertical and horizontal synchronization signals, a data enable signal, and a main clock signal. The timing controller 170 may be configured to perform video processes, such as data compensation, for the data signal from the host system 1000, and then supply the processed or compensated data signal DATA to the data driver 130.

The data driver 130 may be configured to operate based on a data control signal DDC, etc. from the timing controller 170. The data driver 130 may be configured to convert the data signal DATA in a digital form from the timing controller 170 to a data signal in an analog form and then output the analog data signal.

In this regard, the data driver 130 may be configured to convert the data signal DATA in a digital form to the data signal in an analog form based on gamma voltages from a gamma circuit inside or outside the data driver 130. The data driver 130 may be configured to supply the analog data signal to data lines DL1 to DLn of the display panel 110, where n is a positive integer greater than 1.

The gate driver 150 may be configured to operate based on a gate control signal GDC from the timing controller 170. The gate driver 150 may be configured to output a gate signal or a scan signal of a gate high voltage or a gate low voltage.

The gate driver 150 may be configured to sequentially output the gate signal in a forward or reverse direction. The gate driver 150 may be configured to supply the gate signal to gate lines GL1 to GLm of the display panel 110, where m is a positive integer greater than 1.

The power supply 140 may be configured to output a high level voltage (a drain voltage) EVDD and a low level voltage (a source voltage) EVSS for driving the display panel 110, and a collector voltage VCC and a ground voltage GND for driving the data driver 130, etc. Additionally, the power supply 140 may be configured to generate voltages used in operating the display device, such as the gate high voltage or the gate low voltage to be supplied to the gate driver 150.

The display panel 110 may include sub-pixels SP, the data lines DL1 to DLn coupled to the sub-pixels SP respectively, and the gate lines GL1 to GLm coupled to the sub-pixels SP respectively. The display panel 110 may be configured to display an image based on the gate signal from the gate driver 150 and the data signal from the data driver 130. The display panel 110 may include lower and upper substrates. The sub-pixels SP may be disposed between the lower and upper substrates.

As shown in FIG. 2, for example, a single sub-pixel SP may include a switching thin film transistor SW coupled to the gate line GL1 and the data line DL1 (or disposed at an intersection thereof), and a pixel circuit PC configured to operate based on the data signal supplied via the switching thin film transistor SW. The pixel circuit PC may include a drive transistor, a storage capacitor, an organic light-emitting diode, and a pixel compensation circuit (not shown). The pixel compensation circuit may be configured to compensate for at least one of the drive transistor, storage capacitor, and organic light-emitting diode.

The pixel compensation circuit may be configured to compensate for characteristics of the drive transistor (for example, a threshold voltage or current mobility, etc.) and/or characteristics of the organic light-emitting diode (for example, a threshold voltage), and/or for deteriorations thereof. The pixel compensation circuit may operate independently or in association with an external circuit. The pixel compensation circuit may include at least one thin film transistor and capacitor. The pixel compensation circuit can be configured in a wide variety of ways depending on a compensation method. Thus, a specific illustration and description thereof will be omitted.

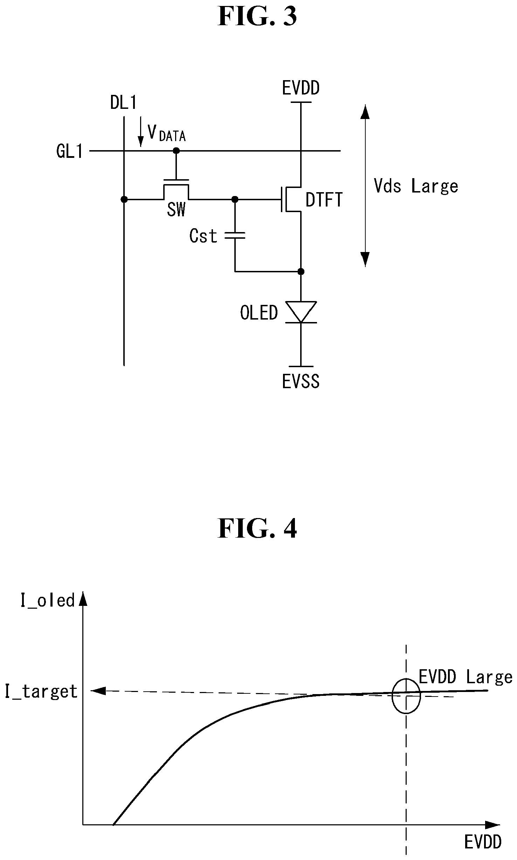

FIG. 3 illustrates a circuit configuration of a related art sub-pixel. FIG. 4 is a graph of a current versus voltage curve of a drive transistor based on a related art driving scheme.

As shown in FIG. 3 and FIG. 4, in the related art driving scheme, a drive transistor DTFT is driven in a saturation region of the current versus voltage curve to operate the sub-pixel. Thus, a high level drive voltage (that is, a high level Vds and EVDD as shown in FIGS. 3 and 4) was used.

In this way, since the related art organic light-emitting display device drives the drive transistor DTFT in the saturation region of the current versus voltage curve, the high level voltage EVDD is used, leading to unnecessarily high power consumption.

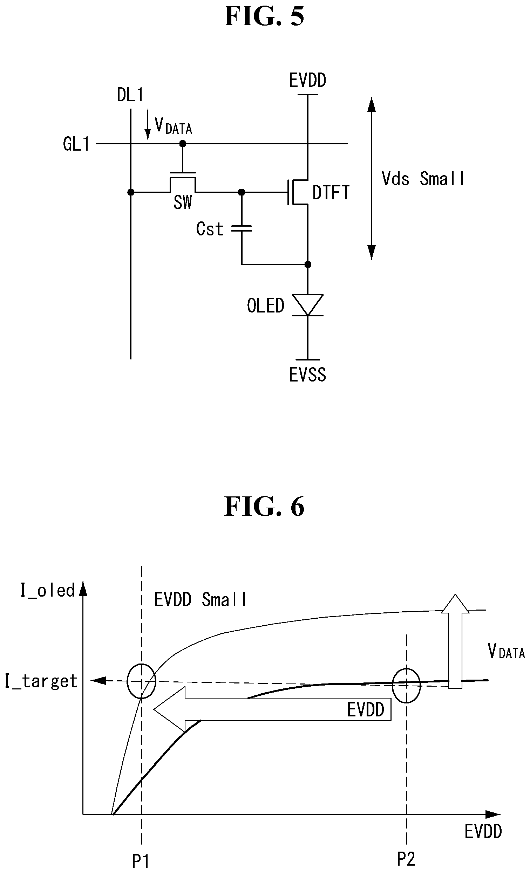

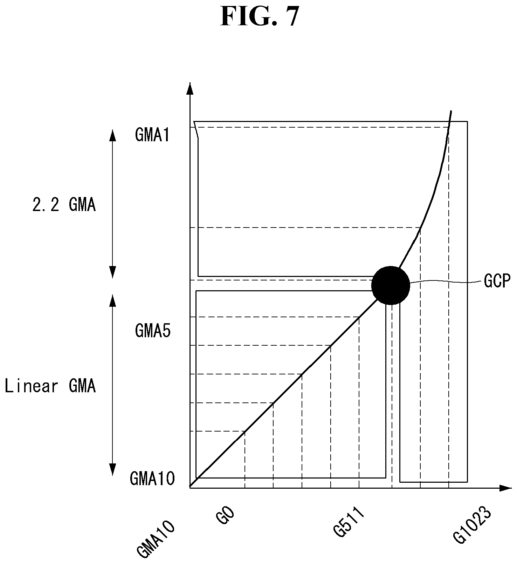

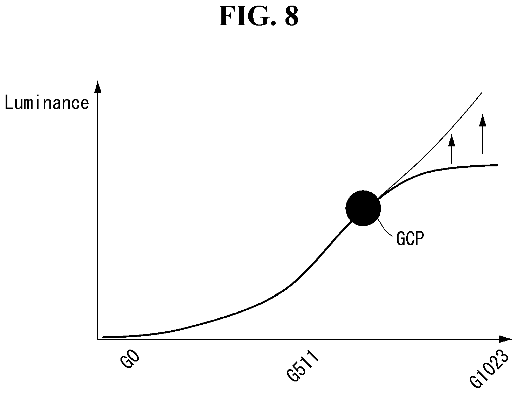

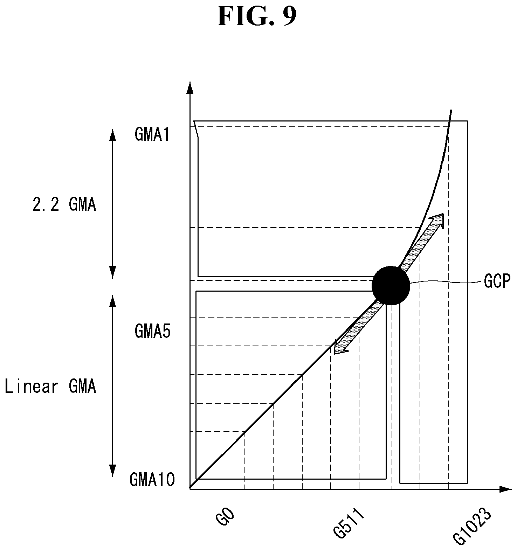

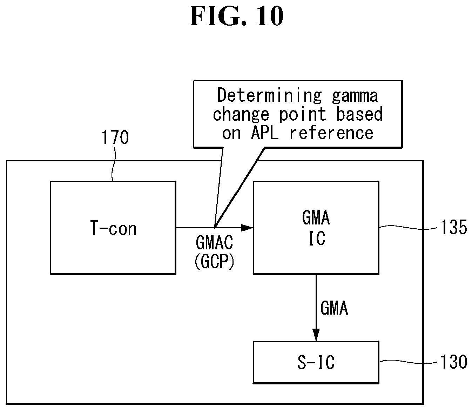

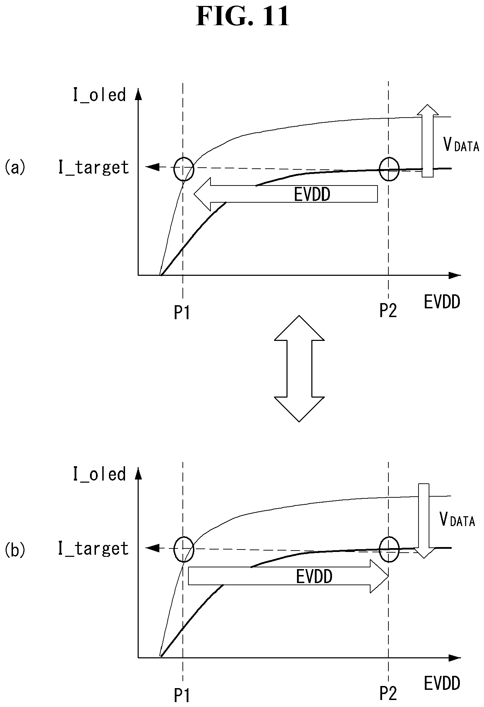

FIG. 5 illustrates a circuit configuration of a sub-pixel in accordance with a first embodiment of the present invention. FIG. 6 is a graph of current versus voltage curves of a drive transistor in accordance with a first embodiment of the present invention. FIG. 7 is a graph of a gamma voltage versus gray-scale curve for describing a gray-scale expression scheme in accordance with a first embodiment of the present invention. FIG. 8 is a graph of a luminance versus gray-scale curve based on a gray-scale expression scheme in FIG. 7. FIG. 9 is a graph of an adaptive gamma curve for gray-scale expression in accordance with a first embodiment of the present invention. FIG. 10 illustrates an exemplary configuration of a device in accordance with a first embodiment of the present invention. FIG. 11 is a graph of current versus voltage curves of a drive transistor for describing a driving method of an organic light-emitting display device in accordance with a first embodiment of the present invention.

As shown in FIG. 5 and FIG. 6, in accordance with a first embodiment of the present invention, to reduce power consumption by an organic light-emitting display device, a drive transistor DTFT of a sub-pixel may be driven using a combination of a saturation region and a linear region of a current versus voltage curve.

Further, to reduce power consumption by the organic light-emitting display device, a level of a high level voltage EVDD may be changed to a lower level than a data voltage V_{DATA} forming a data signal.

For example, in accordance with the first embodiment of the present invention, when the drive transistor DTFT generates a current I_oled for driving an organic light-emitting diode OLED, the high level voltage EVDD, which is one of parameters for generating a target current I_target, may be lowered from a P2 level to a P1 level.

When the drive transistor DTFT of the sub-pixel is driven in the linear region of the curve, the high level voltage EVDD may be set at a lower level compared to a related art method. Thus, a stress level undergone by the transistor may be reduced compared to the related art method. As a result, deterioration of the transistor may be delayed for a longer time period than in the related art method where the drive transistor is driven in the saturation region.

FIG. 5 illustrates, by way of example, a generally-employed 2T1C configuration where two transistors SW and DTFT and a single capacitor Cst are used to drive an organic light- emitting diode OLED. However, the present invention is not limited thereto. Rather, the present invention may be applicable to an organic light-emitting display device with a sub-pixel including various pixel circuit configurations.

As shown in FIG. 7 and FIG. 8, the driving method in accordance with the first embodiment of the present invention may employ a linear gamma (Linear GMA) to express low and middle gray-scale ranges and a non-linear gamma (for example, 2.2 GMA) to express high gray-scale range. This is because when an actual pixel is used to express the gray-scales, the drive transistor DTFT may be driven in the saturation region to express the low and middle gray-scale ranges and in the linear region to express the high gray-scale range.

To this end, the driving method in accordance with the first embodiment of the present invention may employ an adaptive gamma curve including an algorithm for determining a gamma change point (GCP). With the adaptive gamma curve, the GCP may be changed in an adaptive manner.

If the gamma is varied along the adaptive gamma curve, the data voltage may be raised without a separate mechanism when the transistor is driven in the linear region drive. If the adaptive gamma curve is employed, the gamma curve may vary depending on the low, middle, and high gray-scale ranges.

As shown in FIG. 9, the gamma change point (GCP) may be determined based on a data voltage level. The data voltage level may be varied even if it is a voltage for expressing the same gray-scale. This is, for example, because a peak data voltage level may vary based on an average picture level (APL) by a peak luminance control (PLC) algorithm.

Since the data voltage level may be different even for the same gray-scale, the gamma change point (GCP) may be determined based on the peak luminance control (PLC) or the average picture level (APL) reference. As a result, the gamma change point (GCP) may shift down to the linear region or up to the non-linear region based on the data voltage level.

As shown in FIG. 9 and FIG. 10, the gamma change point (GCP) may vary based on characteristics of the data voltage level. Thus, to reflect variations in the characteristics of the data voltage level, the organic light-emitting display device may be configured such that the gamma change point (GCP) at a gamma circuit (GMA IC) 135 may be controlled based on a gamma change signal GMAC from the timing controller (T-con) 170.

In this regard, a module or system for changing a driving scheme for the drive transistor may be contained in the timing controller 170. However, the present invention is not limited thereto. The module or system for changing the driving scheme for the drive transistor may be formed as a separate circuit, in which case the gamma change signal GMAC may be supplied from the separate circuit.

As shown in FIG. 11, in a method for driving the organic light-emitting display device in accordance with the first embodiment of the present invention, to avoid image quality deterioration resulting from the driving of the drive transistor in the linear region, the driving scheme may be changed for an image data anticipated to have such image quality deterioration.

For example, when an image data which is not expected to have such image quality deterioration is input, a driving scheme is carried out as shown in FIG. 11 (a). That is, the drive transistor is driven in the linear region, and the level of the high level voltage EVDD is changed to a level lower than the level of the data voltage V_{DATA}.

On the other hand, when an image data which is expected to have such image quality deterioration is input, a driving scheme is carried out as shown in FIG. 11(b). That is, the drive transistor is driven in the saturation region, and the level of the high level voltage EVDD is changed to a level higher than the level of the data voltage V_{DATA}.

In this regard, to switch the driving schemes of the drive transistor based on whether such image quality deterioration is anticipated for a certain image data, the device may be configured, for example, as discussed below.

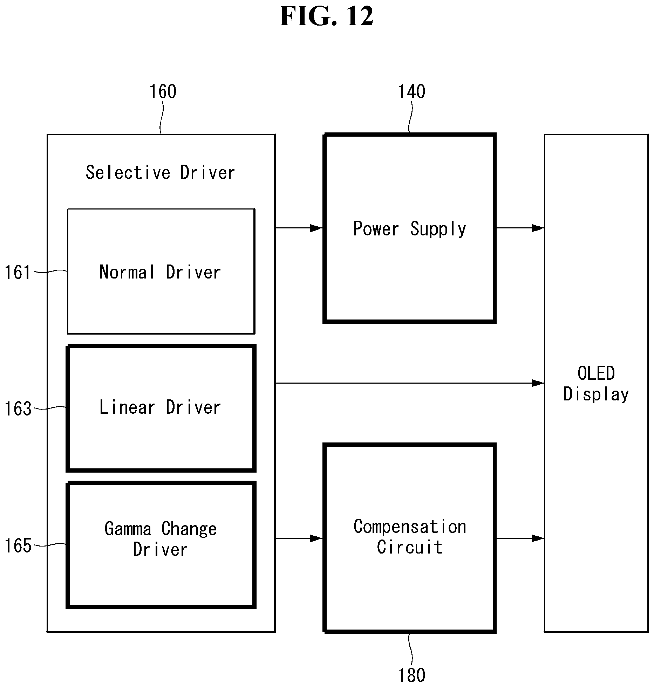

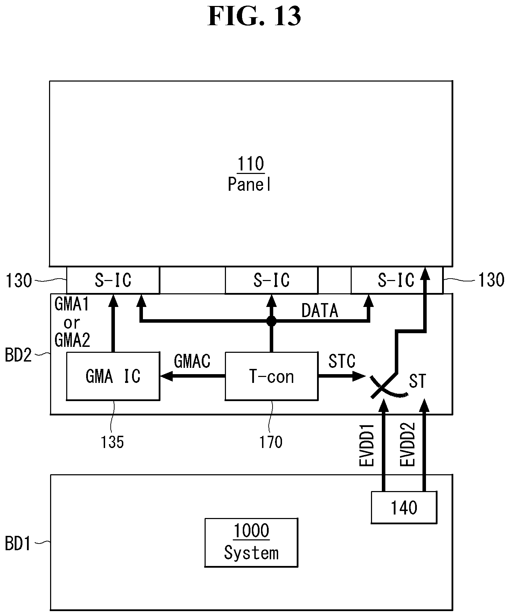

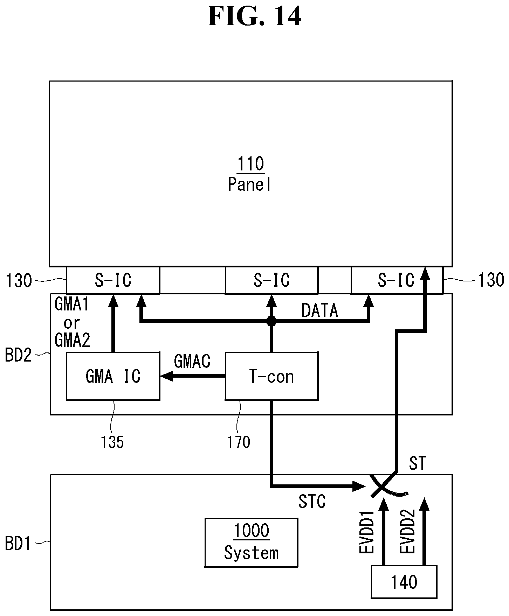

FIG. 12 shows a block diagram of components of interest of an organic light-emitting display device in accordance with a first embodiment of the present invention. FIG. 13 shows a modular configuration in accordance with a first example of the present invention. FIG. 14 shows a modular configuration in accordance with a second example of the present invention.

As shown in FIG. 12, the organic light-emitting display device in accordance with the first embodiment of the present invention may include a selective driver 160, a power supply 140, and a compensation circuit 180. The selective driver 160 and compensation circuit 180 may be integrated into a single module, for example, into a timing controller.

The selective driver 160 may be configured to enable selective driving of a drive transistor of a sub-pixel between the first and the second driving schemes. In the first driving scheme, for example, the drive transistor of the sub-pixel in a display panel may be driven in a saturation region (EVDD > V_{DATA}). In the second driving scheme, for example, the drive transistor of the sub-pixel in the display panel may be driven in the linear region (EVDD < V_{DATA}). For enabling such selective driving, the selective driver 160 may include a non-linear driver (or normal driver) 161, a linear driver 163, and a gamma change driver 165.

The non-linear driver 161 may be configured to generate a first drive control signal to instruct the first driving scheme to be carried out. That is, using the first drive control signal, the drive transistor of the sub-pixel in the display panel may be driven in the saturation or non-linear region. In this regard, when the non-linear driver 161 outputs the first drive control signal to the power supply 140, the power supply 140 may be configured to change the level of the high level voltage EVDD to a level higher than the level of the data voltage V_{DATA}.

The linear driver 163 may be configured to generate a second drive control signal to instruct the second driving scheme to be carried out. That is, using the second drive control signal, the drive transistor of the sub-pixel in the display panel may be driven in the linear or non-saturation region. In this regard, when the linear driver 163 outputs the second drive control signal to the power supply 140, the power supply 140 may be configured to change the level of the high level voltage EVDD to a level lower than the level of the data voltage V_{DATA}.

The linear driver 163 may force the drive transistor of the sub-pixel in the display panel to be driven in the saturation region when an image data with expected image quality deterioration is input. In other words, even if the driving scheme is set to the second driving scheme for the linear driver 163, the linear driver 163 may force performing the first driving scheme in the saturation region, not the second driving scheme in the linear region, when an image data with expected image quality deterioration is input.

To this end, the linear driver 163 may be configured to reference a lookup table which parameters one or more factors for predicting or forecasting image quality deterioration. The lookup table may be stored in a memory as data. Alternatively, the linear driver 163 may be configured to predict the image quality deterioration using an image analysis algorithm.

The factors for predicting or forecasting the image quality deterioration may include, but are not limited to, an average picture level (APL), a total current flowing in the organic light-emitting diode (total EL current), a peak value of the gray-scale, an image complexity, a drive frequency, a crosstalk pattern, and so on. These factors may be provided as parametric threshold values through experiments.

The linear driver 163 may be configured to compare parameter values of the current image data with the parametric threshold values in the lookup table and to enable the drive transistor to be driven in the saturation region, for example, only when the parameter value(s) of the current image data is or are determined to be smaller than the respective parametric threshold value(s).

For example, upon determination that the image quality deterioration is expected to occur, the linear driver 163 may operate together with the non-linear driver 161 such that the first drive control signal from the non-linear driver 161 is changed to a logic high, instead of the second drive control signal from the linear driver 163 being changed to a logic low.

The gamma change driver 165 may be configured to set a gamma based on characteristics parameters in accordance with a predetermined condition for the present device. The gamma change driver 165 may be configured to output a gamma change signal to determine a gamma change point at a gamma circuit based on a change in the driving schemes. The gamma change driver 165 may be configured to output the gamma change signal based on the characteristics parameters such as the peak luminance control (PLC) and/or average picture level (APL).

The compensation module or circuit 180 may be configured to analyze a data signal to be supplied to the display panel, and to compensate and improve for variation of the display panel resulting from the selective driving between the first and the second driving schemes respectively using the saturation region and the linear region. Further, the compensation module or circuit 180 may be configured to compensate for the variation of the display panel resulting from a change in the gamma change point.

Further, the compensation module 180 may be configured to calculate a display panel characteristics variation, for example, an IR drop resulting from the driving in the linear region and then to compensate for the variation. To this end, the compensation module 180 may be configured to generate and output a compensation signal for compensating for the display panel characteristics variation based on an analysis of the data signal and the gamma change signal from the gamma change driver 165.

In accordance with the first embodiment of the present invention, the power consumption of the device may be reduced while the deterioration of the drive transistor may be delayed via the selective driving scheme based on the image quality deterioration estimation. To that end, a drive control signal may be generated to enable selective driving between the first and the second driving schemes for the drive transistor of the sub-pixel, where the first and the second schemes respectively employ the saturation and the linear regions for the drive transistor. Then, based on the selected driving scheme, a gamma change signal may be generated to change the gamma based on the selected driving scheme, and/or a level of a high level voltage (e.g., EVDD) to be supplied to the sub-pixel may be changed.

Hereinafter, an example modular configuration of an organic light-emitting display device will be described where the selective driver 160 and compensation module 180 are incorporated into the timing controller 170.

As shown in FIG. 13 illustrating a first example modular configuration of the organic light-emitting display device, the organic light-emitting display device may be modularized with a first circuit board BD1, a second circuit board BD2 and a display panel 110. The first circuit board BD1 may include a host system 1000 and a power supply 140 disposed thereon. The second circuit board BD2 may include the timing controller 170, the gamma circuit 135, and a voltage switching circuit ST disposed thereon. The voltage switching circuit ST may be disposed inside or outside the power supply 140.

As shown in FIG. 14 illustrating a second example modular configuration of the organic light-emitting display device, the organic light-emitting display device may be modularized with a first circuit board BD1, a second circuit board BD2, and a display panel 110. The first circuit board BD1 may include a host system 1000, a power supply 140 and a voltage switching circuit ST disposed thereon. The second circuit board BD2 may include a timing controller 170 and a gamma circuit 135 disposed thereon. The voltage switching circuit ST may be disposed inside or outside the power supply 140.

The timing controller 170 may be configured to output a switch control signal STC to selectively supply a first high level voltage EVDD1 or a second high level voltage EVDD2 from the power supply 140 disposed on the first circuit board BD1. In one example, the first high level voltage EVDD1 (a saturation region drive voltage) may be higher than the second high level voltage EVDD2 (a linear region drive voltage).

The timing controller 170 may be configured to generate a first switch control signal at the same time when the first drive control signal is generated by the non-linear driver disposed therein to drive the drive transistor in the saturation region, that is, a normal driving condition.

Further, the timing controller 170 may be configured to output a gamma change signal GMAC when there is a need for a gamma change. For example, the gamma circuit 135 may be configured to supply a gamma voltage GMA1 complying with a first gamma curve to a data driver 130 based on the gamma change signal GMAC.

When the timing controller 170 has outputted the first drive control signal and the first switch control signal, the voltage switching circuit ST may be configured to operate such that the first high level voltage EVDD1 from the power supply 140 is supplied to the display panel 110. In this way, the display panel 110 may operate based on an operating condition of the saturation region.

The timing controller 170 may be configured to generate a second switch control signal at the same time when the second drive control signal is generated by the linear driver disposed therein to drive the drive transistor in the linear region, that is, a change driving condition.

Further, the timing controller 170 may be configured to output a gamma change signal GMAC when there is a need for a gamma change. For example, the gamma circuit 135 may be configured to supply a gamma voltage GMA2 complying with a second gamma curve to the data driver 130 based on the gamma change signal GMAC.

When the timing controller 170 has outputted the second drive control signal and the second switch control signal, the voltage switching circuit ST may be configured to operate such that the second high level voltage EVDD2 from the power supply 140 is supplied to the display panel 110. In this way, the display panel 110 may operate based on an operating condition of the linear region.

As described above, in accordance with example embodiments of the present invention, to change the level of the high level voltage, the voltage switching circuit ST may receive the first and the second high level voltages EVDD1 and EVDD2 from the first circuit board BD1 having the host system 1000 and the power supply 140, and select one of the two high level voltages EVDD1 and EVDD2 based on the computing result (parameter computing result) by the timing controller 170, as illustrated in FIG. 13. Alternatively, the voltage switching circuit ST may receive as a feedback the computing result by the timing controller 170 and select one of the two high level voltages EVDD1 and EVDD2 based on the feedback, as illustrated in FIG. 14. These two approaches are merely examples. As another alternative, for example, the power supply 140 and timing controller 170 both may be disposed on the second circuit board BD2. The present invention is not limited to the above example configurations.

### <A second embodiment >

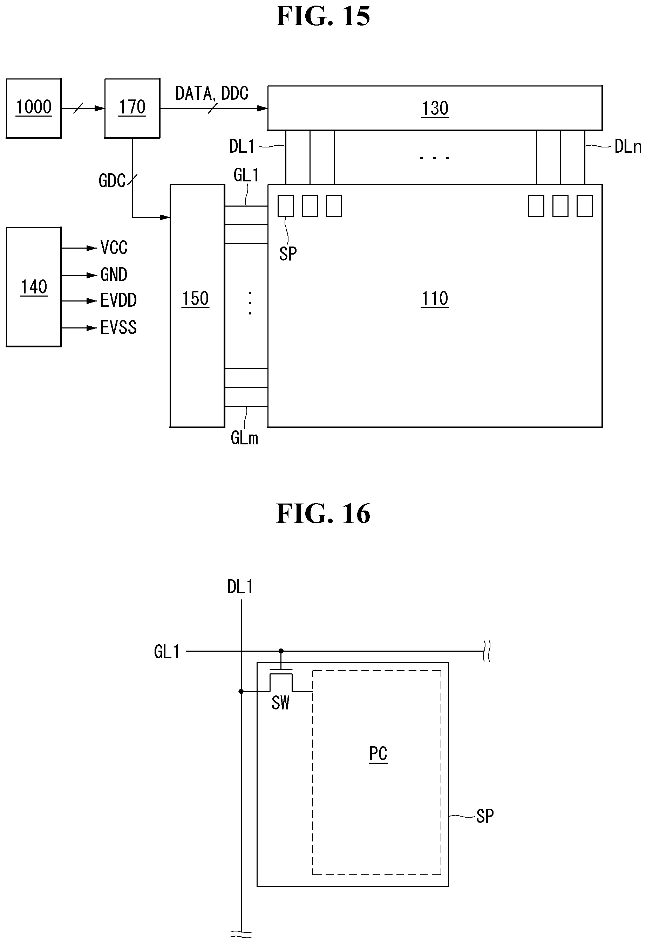

FIG. 15 is a schematic block view of an organic light-emitting display device in accordance with a second embodiment of the present invention. FIG. 16 schematically illustrates a configuration of a sub-pixel in FIG. 15.

As shown in FIG. 15, the organic light-emitting display device may include a host system 1000, a timing controller 170, a data driver 130, a power supply 140, a gate driver 150, and a display panel 110.

The host system 1000 may include a SoC (System on Chip) having a scaler disposed therein, and may convert digital video data of an input video to a data signal with a suitable format for display on the display panel 110, and then output the converted data signal. The host system 1000 may supply a variety of timing signals along with the data signal to the timing controller 170.

The timing controller 170 may be configured to control operation timings of the data driver 130 and gate driver 150 based on timing signals from the host system 1000, such as based on vertical and horizontal synchronization signals, a data enable signal, a main clock signal, etc. The timing controller 170 may be configured to perform video process, such as data compensation, for the data signal from the host system 1000, and then supply the processed or compensated data signal to the data driver 130.

The data driver 130 may be configured to operate based on a data control signal DDC, etc. from the timing controller 170. The data driver 130 may be configured to convert the data signal DATA in a digital form from the timing controller 170 to a data signal in an analog form and then output the analog signal.

In this regard, the data driver 130 may be configured to convert the data signal DATA in a digital form to the data signal in an analog form based on gamma voltages from a gamma circuit inside or outside the data driver 130. The data driver 130 may be configured to supply the analog data signal to data lines DL1 to DLn of the display panel 110.

The gate driver 150 may be configured to operate based on a gate control signal GDC from the timing controller 170. The gate driver 150 may be configured to output a gate signal or a scan signal of a gate high voltage or a gate low voltage.

The gate driver 150 may be configured to sequentially output the gate signal in forward or reverse direction. The gate driver 150 may be configured to supply the gate signal to gate lines GL1 to GLm of the display panel 110.

The power supply 140 may be configured to output a high level voltage (a drain voltage) EVDD and a low level voltage (a source voltage) EVSS for driving the display panel 110, and a collector voltage VCC and a ground voltage GND for driving the data driver 130, etc. Additionally, the power supply 140 may be configured to generate voltages required for operations of the display device, such as the gate high voltage or the gate low voltage to be supplied to the gate driver 150.

The display panel 110 may include sub-pixels SP, the data lines DL1 to DLn coupled to the sub-pixels SP respectively, and the gate lines GL1 to GLm coupled to the sub-pixels SP respectively. The display panel 110 may be configured to display an image based on the gate signal from the gate driver 150 and the data signal from the data driver 130. The display panel 110 may include lower and upper substrates. The sub-pixels SP may be disposed between the lower and upper substrates.

As shown in FIG. 16, a single sub-pixel includes a switching thin film transistor SW coupled to the gate line GL1 and data line DL1 (or disposed at an intersection thereof), and a pixel circuit PC configured to operate based on the data signal supplied via the switching thin film transistor SW. The pixel circuit PC may include a drive transistor, a storage capacitor, an organic light-emitting diode, and a pixel compensation circuit. The pixel compensation circuit may be configured to compensate for at least one of the drive transistor, storage capacitor, and organic light-emitting diode.

The pixel compensation circuit may be configured to compensate for characteristics of the drive transistor (for example, a threshold voltage, current mobility, etc.), and/or characteristics of the organic light-emitting diode (for example, a threshold voltage) and/or for deteriorations thereof. The pixel compensation circuit may operate independently or in association with an external circuit. The pixel compensation circuit may include at least one thin film transistor and capacitor. The pixel compensation circuit can be configured in a wide variety of ways depending on a compensation method. Thus, a specific illustration and description thereof will be omitted.

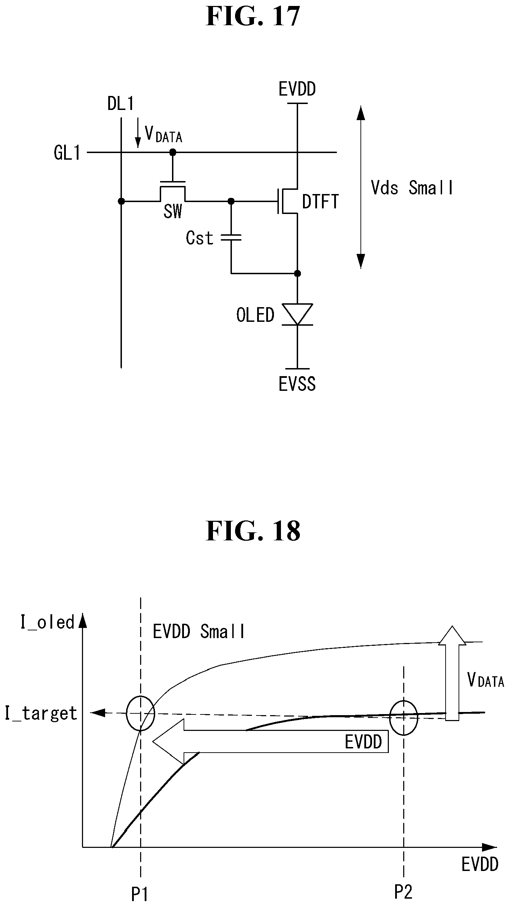

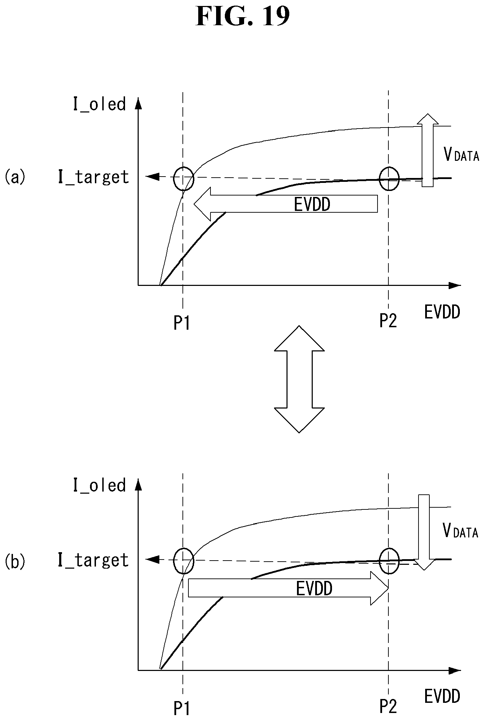

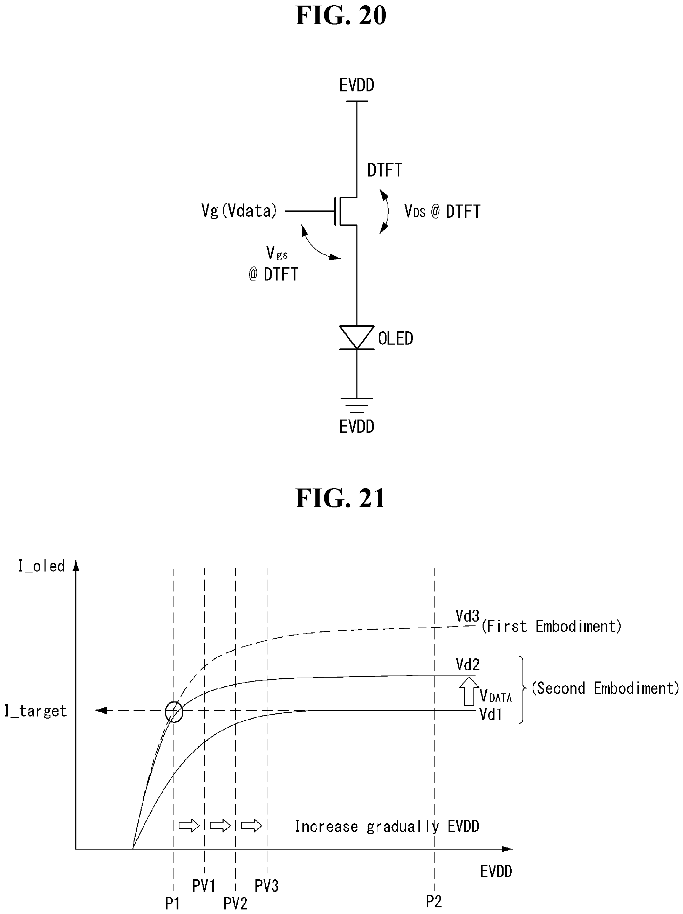

FIG. 17 illustrates a circuit configuration of a sub-pixel in accordance with a second embodiment of the present invention. FIG. 18 is a graph of current versus voltage curves of a drive transistor in accordance with a second embodiment of the present invention. FIG. 19 is a graph of a voltage versus gray-scale curve of a drive transistor for describing a driving method of an organic light-emitting display device in accordance with a second embodiment of the present invention. FIG. 20 describes a problem of deterioration of a drive transistor. FIG. 21 is a graph of current versus voltage curves for a drive transistor for describing a high level voltage changing scheme in accordance with a second embodiment of the present invention.

As shown in FIG. 17 and FIG. 18, in accordance with a second embodiment of the present invention, in order to achieve power consumption reduction for the organic light-emitting display device, a drive transistor DTFT of a sub-pixel may be driven using a combination of a saturation region and a linear region of a current versus voltage curve.

Further, in order to achieve power consumption reduction for the organic light-emitting display device, a level of a high level voltage EVDD may be changed to a level lower than a level of a data voltage V_{DATA} forming a data signal.

For example, in accordance with the second embodiment of the present invention, when the drive transistor generates a current I_oled for driving an organic light-emitting diode, a level of the high level voltage EVDD, which is one of parameters for generating a target current I_target, may be lowered from a P2 level to a P1 level.

When the drive transistor DTFT of the sub-pixel is driven in the linear region of the curve, the level of the high level voltage EVDD may be lowered compared to the related art method. Thus, a stress level undergone by the transistor may be reduced compared to the related art method. As a result, deterioration of the transistor may be expected to be delayed for a longer time period than in the related art method where the drive transistor is driven in the saturation region.

FIG. 17 illustrates, by way of example, a generally-employed 2T1C configuration where two transistors SW and DTFT and a single capacitor Cst are used to drive an organic light-emitting diode OLED. However, the present invention is not limited thereto. Rather, the present invention may be applicable to an organic light-emitting display device with a sub-pixel including various pixel circuit configurations.

The driving method in accordance with the second embodiment of the present invention, as in the first embodiment of the present invention, may employ a linear gamma (Linear GMA) for expression of low and middle gray-scale ranges, and employ a non-linear gamma (for example, 2.2 GMA) for expression of a high gray-scale range. This is because when expressing the gray-scale using the actual pixel, the drive transistor is driven in the saturation region for the expression of the low and middle gray-scale ranges, and in the linear region for the expression of the high gray-scale range.

As shown in FIG. 19, in a method for driving the organic light-emitting display device in accordance with the second embodiment of the present invention, in order to avoid image quality deterioration resulting from the driving of the drive transistor in the linear region, an image data which is expected to have such image quality deterioration may be subjected to a different driving scheme.

For example, when an image data which is not expected to have such image quality deterioration is input, a driving scheme is carried out as shown in FIG. 19(a). That is, the drive transistor is driven in the linear region, and the level of the high level voltage EVDD is changed to a level lower than the level of the data voltage V_{DATA}.

To the contrary, when an image data which is expected to have such image quality deterioration is input, a driving scheme is carried out as shown in FIG. 19(b). That is, the drive transistor is driven in the saturation region, and the level of the high level voltage EVDD is changed to a level higher than the level of the data voltage V_{DATA}.

However, as can be seen in FIG. 19(a), it is necessary to increase the data voltage V_{DATA} to satisfy a target current I_target when the drive transistor is driven in the linear region. As such, an example of the timing in which the data voltage V_{DATA} to satisfy the target current I_target should be increased may by explained as follows:

As shown in FIG. 20, when the driving time of the drive transistor DTFT is continued or a positive voltage is applied continuously to the drive transistor DTFT, a threshold voltage Vth is shifted in a positive direction due to the image quality deterioration. In this case, a Vgs (or Vgs-Vth) of the drive transistor DTFT is lowered gradually, so the data voltage V_{DATA} should be further increased to satisfy the target current I_target.

Therefore, when the threshold voltage of the drive transistor DTFT is shifted in the positive direction due to the image quality deterioration, the data voltage V_{DATA} should be further increased, however, in this case, the constraints may arise due to the limited output range of the data driver. That is to say, it is difficult to cope with such a problem such as a situation where the data driver cannot increase the data voltage V_{DATA} beyond a constant range due to the limited output range.

Additionally, if a problem such as image quality deterioration is caused continuously, the deterioration deviation of the threshold voltage is scattered on a basis of position or sub-pixel of the display panel, which results in increased screen stain on the display panel and decreased life time of the display panel. According to experimental results, this problem may appear more serious when the drive transistor is driven in the linear region, therefore, in accordance with the second embodiment of the present invention, it may be improved as follows:

As shown in FIG. 21, when an image data which is not expected to have such image quality deterioration is input, the driving transistor is driven in the linear region, a level of the high level voltage EVDD may be changed to a level lower than a level of the data voltage V_{DATA}. At the same time, it may maintain the target current I_target by avoiding the increase in a data voltage V_{DATA} and gradually increasing the level of the high level voltage EVDD depending on the deterioration characteristic of the drive transistor.

That is, in accordance with the second embodiment of the present invention, the drive transistor is driven in the linear region, the deterioration characteristic of the drive transistor, for example, the threshold voltage, is monitored or sensed. Further, when the deterioration characteristic of the drive transistor, for example, the threshold voltage, deviates from a reference range (for example, a reference threshold voltage) set inside the timing controller 170, the increase in a data voltage V_{DATA} is avoided and a level of the high level voltage EVDD is increased gradually.

To facilitate understanding of the descriptions, a comparison of the first embodiment with the second embodiment may be described as follows:

In the first embodiment, in order to drive the drive transistor in the linear region and generate the target current I_target, a level of the high level voltage EVDD is lowered from P2 level to P1 level, and the data voltage V_{DATA} is increased to Vd3.

In the second embodiment, in order to drive the drive transistor in the linear region and generate the target current I_target, a level of the high level voltage EVDD is lowered from P2 level to P1 level, and the data voltage V_{DATA} is maintained in a previous level such as Vd1, or increased to Vd2 by a small amount. Further, in the second embodiment, the deterioration characteristic of the drive transistor, for example, the threshold voltage, is monitored or sensed, and in response to changes in the deterioration characteristic of the drive transistor, for example, the threshold voltage, the levels PV1, PV2, PV3 of the high level voltage EVDD are increased gradually.

The levels PV1, PV2, PV3 of the high level voltage EVDD are increased gradually, for example, in a P2 direction in proportion to the changes in the threshold voltage. As such, in the second embodiment, the levels PV1, PV2, PV3 of the high level voltage EVDD are also changed taking account of the deterioration characteristic and compensation margin of the drive transistor. At this time, since the gradually changed high level voltage EVDD is commonly supplied to all of the sub-pixels of the display panel, a global compensation effect can be expected.

As explained above, it is difficult to obtain a margin that can satisfy a target current I_target only by increasing a data voltage V_{DATA}, when the threshold voltage of the drive transistor DTFT is changed in a positive direction beyond a constant value, for example, a reference threshold voltage set by the experiment. However, in accordance with the second embodiment of the present invention, a margin being capable of satisfying a target current I_target is obtained, since it is possible to perform an additional compensation from the data voltage V_{DATA}, when the levels PV1, PV2, PV3 of the high level voltage EVDD are changed in response to changes in the threshold voltage of the drive transistor.

Accordingly, in accordance with the second embodiment of the present invention, it is possible to secure a compensation range (for example, an output range that is necessary to compensate for the data voltage) of the data voltage V_{DATA} in a larger width compared to the first embodiment, since the margin capable of changing the data voltage V_{DATA} is increased.

In this connection, as in the second embodiment, in order to switch the driving schemes of the drive transistor based on whether such an image quality problem occurs for a certain image data, and change the level of high level voltage EVDD gradually, the present device may be configured as follows:

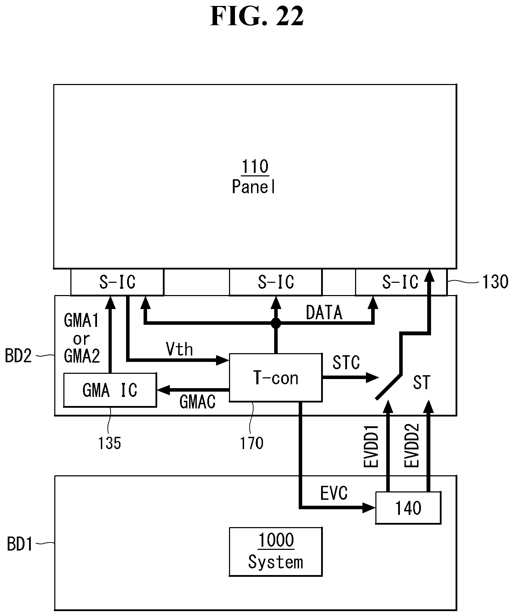

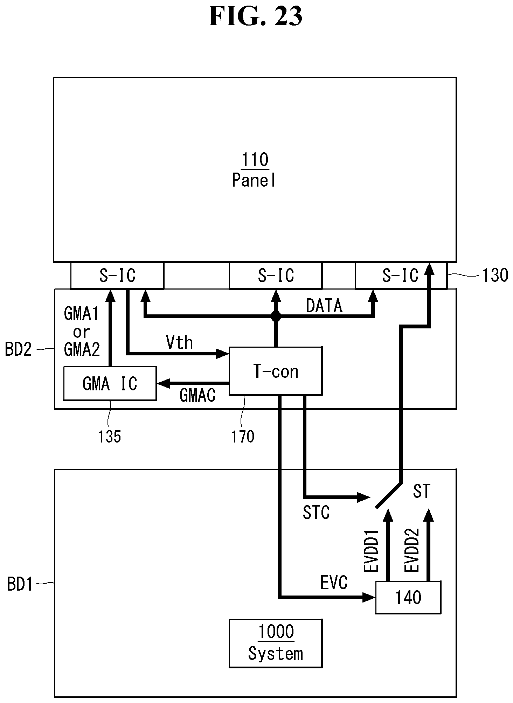

FIG. 22 shows a modular configuration in accordance with a third example of the present invention. FIG. 23 shows a modular configuration in accordance with a fourth example of the present invention.

As shown in FIG. 22 illustrating a third example modular configuration of an organic light-emitting display device, the organic light-emitting display device may be modularized with a first circuit board BD1, a second circuit board BD2 and a display panel 110. The first circuit board BD1 may include a system 1000 and a power supply 140 disposed thereon. The second circuit board BD2 may include a timing controller 170, a gamma circuit 135, and a voltage switching circuit ST disposed thereon. The voltage switching circuit ST may be disposed inside or outside the power supply 140. The gamma circuit 135 also performs the same functions or operations as those shown in the first example or the second example. However, since this is not principal features of the second embodiment, the descriptions thereof may be discussed with reference to the portion of the first example or the second example of the present invention.

As shown in FIG. 23 illustrating a fourth example modular configuration of the organic light-emitting display device, the organic light-emitting display device may be modularized with a first circuit board BD1, a second circuit board BD2 and a display panel 110. The first circuit board BD1 may include a host system 1000, a power supply 140 and a voltage switching circuit ST disposed thereon. The second circuit board BD2 may include a timing controller 170 and a gamma circuit 135 disposed thereon. The voltage switching circuit ST may be disposed inside or outside the power supply 140. The gamma circuit 135 also performs the same functions or operations as those shown in the first example or the second example. However, since this is not principal features of the second embodiment, the descriptions thereof may be discussed with reference to the portion of the first example or the second example of the present invention.

The timing controller 170 may be configured to output a switch control signal STC to selectively supply a first high level voltage EVDD1 and a second high level voltage EVDD2 from the power supply 140 disposed on the first circuit board BD1. In one example, the first high level voltage EVDD1 (a saturation region drive voltage) may be higher than the second high level voltage EVDD2 (a linear region drive voltage).

The timing controller 170 may be configured to generate a first switch control signal at the same time when a first drive control signal is generated by a non-linear driver disposed therein, wherein the first drive control signal enables driving for the drive transistor in a saturation region, that is, a normal driving condition.

When the timing controller 170 has outputted the first drive control signal and first switch control signal, the voltage switching circuit ST may be configured to operate such that the first high level voltage EVDD1 from the power supply 140 is supplied to the display panel 110. In this way, the display panel 110 may operate based on an operation condition of the saturation region.

The timing controller 170 may be configured to generate a second switch control signal at the same time when a second drive control signal is generated by a linear driver disposed therein, wherein the second drive control signal enables driving for the drive transistor in a linear region, that is, a change driving condition.

Further, the timing controller 170 monitors or senses deterioration characteristic of the drive transistor, for example, Vth, continuously, and generates a power variable signal EVC to increase a level of a high level voltage EVDD gradually based on the deterioration characteristic of the drive transistor, for example, Vth. At this time, the timing controller 170 performs compensation operations to avoid an increase in a data voltage V_{DATA} and gradually increase the level of the high level voltage EVDD, when the deterioration characteristic of the drive transistor, for example, Vth deviates from a reference range (a reference threshold voltage) set inside the timing controller 170.

When the timing controller 170 has outputted the second drive control signal and second switch control signal, the voltage switching circuit ST may be configured to operate such that the second high level voltage EVDD2 from the power supply 140 is supplied to the display panel 110. In this way, the display panel 110 may operate based on an operation condition of the linear region. When the timing controller 170 has outputted the power variable signal EVC, the power supply 140 changes a level of the second high level voltage EVDD2 based on the compensation operations by the timing controller 170 and outputs the level.

### <A third embodiment >

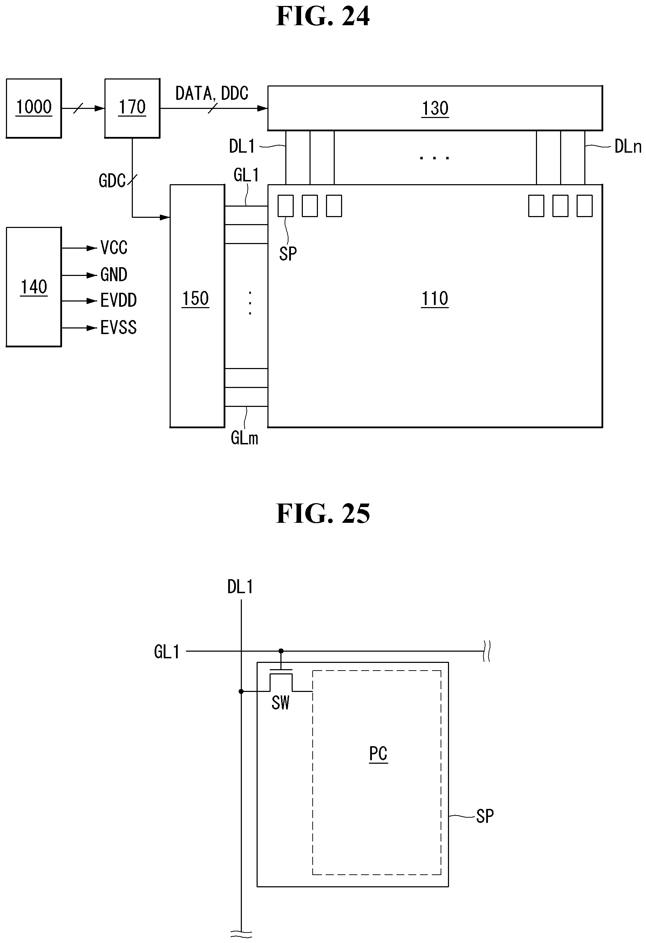

FIG. 24 is a schematic block view of an organic light-emitting display device in accordance with a third embodiment of the present invention. FIG. 25 schematically illustrates a configuration of a sub-pixel in FIG. 24.

As shown in FIG. 24, the organic light-emitting display device may include a host system 1000, a timing controller 170, a data driver 130, a power supply 140, a gate driver 150, and a display panel 110.

The host system 1000 may include a SoC (System on Chip) having a scaler disposed therein, and may convert digital video data of an input video to a data signal with a suitable format for display on the display panel 110, and then output the converted data signal. The host system 1000 may supply a variety of timing signals along with the data signal to the timing controller 170.

The timing controller 170 may be configured to control operation timings of the data driver 130 and gate driver 150 based on the timing signals from the host system 1000, such as based on vertical and horizontal synchronization signals, a data enable signal, a main clock signal, etc. The timing controller 170 may be configured to perform video process, such as data compensation, for the data signal from the host system 1000, and then supply the processed or compensated data signal to the data driver 130.

The data driver 130 may be configured to operate based on a data control signal DDC, etc. from the timing controller 170. The data driver 130 may be configured to convert the data signal DATA in a digital form from the timing controller 170 to a data signal in an analog form and then output the converted data signal.

In this regard, the data driver 130 may be configured to convert the data signal DATA in a digital form to the data signal in an analog form based on gamma voltages from a gamma circuit inside or outside the data driver 130. The data driver 130 may be configured to supply the analog data signal to data lines DL1 to DLn of the display panel 110.

The gate driver 150 may be configured to operate based on a gate control signal GDC from the timing controller 170. The gate driver 150 may be configured to output a gate signal or a scan signal of a gate high voltage or a gate low voltage.

The gate driver 150 may be configured to sequentially output the gate signal in a forward or reverse direction. The gate driver 150 may be configured to supply the gate signal to gate lines GL1 to GLm of the display panel 110.

The power supply 140 may be configured to output a high level voltage (a drain voltage) EVDD and a low level voltage (a source voltage) EVSS for driving the display panel 110, and a collector voltage VCC and a ground voltage GND for driving the data driver 130, etc. Additionally, the power supply 140 may be configured to generate voltages required for operations of the display device, such as the gate high voltage or the gate low voltage to be supplied to the gate driver 150.

The display panel 110 may include sub-pixels SP, the data lines DL1 to DLn coupled to the sub-pixels SP respectively, and the gate lines GL1 to GLm coupled to the sub-pixels SP respectively. The display panel 110 may be configured to display an image based on the gate signal from the gate driver 150 and the data signal from the data driver 130. The display panel 110 may include lower and upper substrates. The sub-pixels SP may be disposed between the lower and upper substrates.

As shown in FIG. 25, a single sub-pixel includes a switching thin film transistor SW coupled to the gate line GL1 and data line DL1 (or disposed at an intersection thereof), and a pixel circuit PC configured to operate based on the data signal supplied via the switching thin film transistor SW. The pixel circuit PC may include a drive transistor, a storage capacitor, an organic light-emitting diode, and a pixel compensation circuit. The pixel compensation circuit may be configured to compensate for at least one of the drive transistor, storage capacitor, and organic light-emitting diode.

The pixel compensation circuit may be configured to compensate for characteristics of the drive transistor (for example, a threshold voltage, current mobility, etc.), and/or characteristics of the organic light-emitting diode (for example, a threshold voltage) and/or for deteriorations thereof. The pixel compensation circuit may operate independently or in association with an external circuit. The pixel compensation circuit may include at least one thin film transistor and capacitor. The pixel compensation circuit can be configured in a wide variety of ways depending on a compensation method. Thus, a specific illustration and description thereof will be omitted.

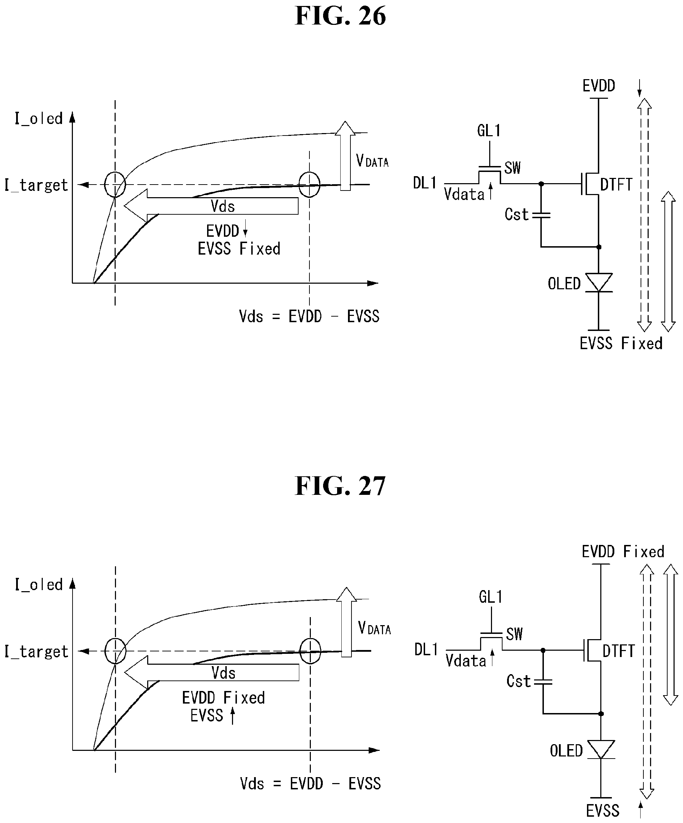

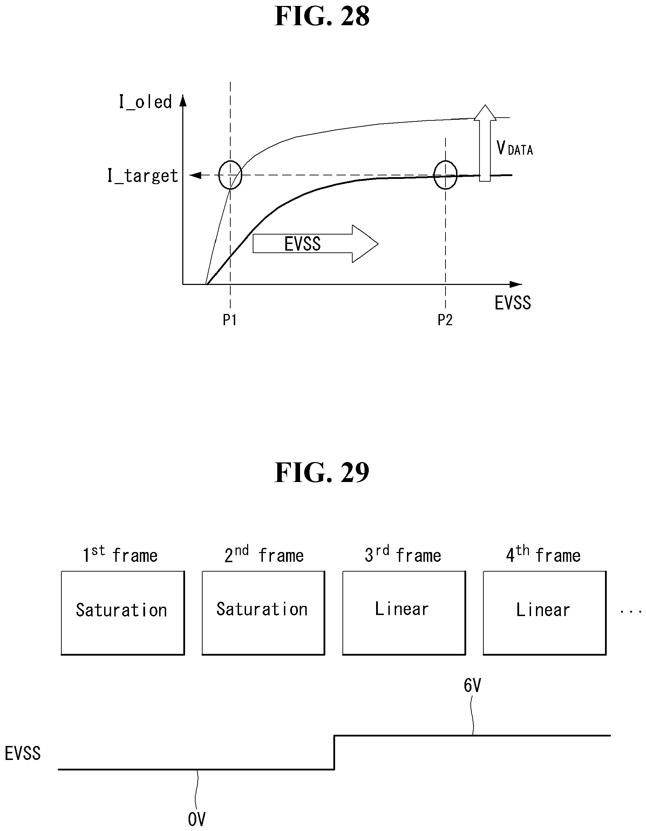

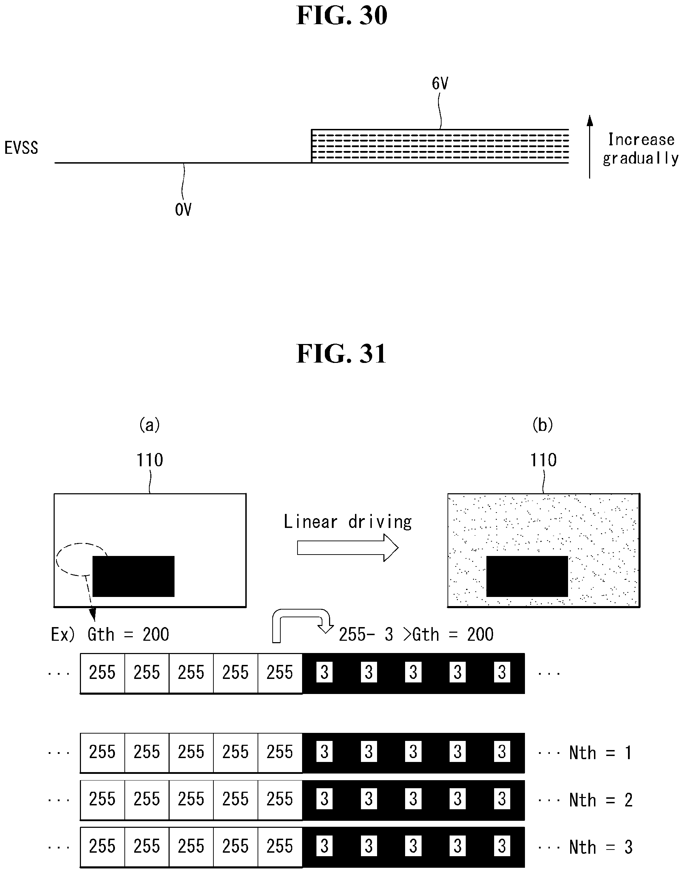

FIGS. 26 and 27 are diagrams for describing a comparison between a scheme of changing a level of a high level voltage and a scheme of changing a level of a low level voltage in order to drive a drive transistor in a linear region and generate a target current. FIG. 28 is a graph of current versus voltage curves of a drive transistor for describing a driving method of an organic light-emitting display device in accordance with a third embodiment of the present invention. FIGS. 29 and 30 are views illustrating examples of changing a low level voltage in accordance with a third embodiment of the present invention.

As shown in FIG. 26, the second embodiment lowers a level of a high level voltage EVDD to drive a drive transistor DTFT in a linear region and generate a target current I_target but maintains a data voltage V_{DATA} at a previous level or slightly increases the data voltage V_{DATA} from the previous level. To this end, the second embodiment changes the high level voltage EVDD while a low level voltage EVSS is fixed.

As shown in FIG. 27, the third embodiment increases a level of the low level voltage EVSS to drive the drive transistor DTFT in the linear region and generate the target current I_target but maintains the data voltage V_{DATA} at the previous level or slightly increases the data voltage V_{DATA} from the previous level. To this end, the third embodiment changes the low level voltage EVSS while the high level voltage EVDD is fixed.

As can be seen from FIGS. 26 and 27, a drain-source voltage Vds of the drive transistor DTFT = the high level voltage EVDD - the low level voltage EVSS is also defined in the third embodiment as well as the second embodiment. That is, when one of the level of the high level voltage EVDD and the level of the low level voltage EVSS is lowered, the drain-source voltage Vds of the drive transistor DTFT is also lowered. Therefore, since a method of changing the level of the high level voltage EVSS as well as a method of changing the level of the high level voltage EVDD changes the voltage depending on a change of a threshold voltage of the drive transistor DTFT, both embodiments can improve life time of the product.

FIG. 27 illustrates, by way of example, a generally-employed 2T1C configuration where two transistors SW and DTFT and a single capacitor Cst are used to drive an organic light-emitting diode OLED. However, the present invention is not limited thereto. Rather, the present invention may be applicable to an organic light-emitting display device with a sub-pixel including various pixel circuit configurations.

As shown in FIG. 28, in accordance with the third embodiment of the present invention, in order to achieve power consumption reduction for the organic light-emitting display device, the drive transistor DTFT of the sub-pixel may be driven using a combination of a saturation region and a linear region of a current versus voltage curve. Further, in order to achieve power consumption reduction for the organic light-emitting display device, a level of the low level voltage EVSS may be changed in response to a change of the data voltage V_{DATA} constituting a data signal.

For example, in accordance with the third embodiment of the present invention, when the drive transistor generates a current I_oled for driving the organic light-emitting diode, the level of the low level voltage EVSS, which is one of conditions for generating the target current I_target, becomes higher than P1. However, this condition is satisfied when the drive transistor DTFT is driven in the linear region rather than the saturation region.

As shown in first and second frames (1st frame, 2nd frame) of FIG. 29, when the drive transistor DTFT is driven in the saturation region, the level of the low level voltage EVSS is maintained at 0V level.

As shown in third and fourth frames (3rd frame, 4th frame) in FIG. 29, when the drive transistor DTFT is driven in the linear region, the level of the low level voltage EVSS is maintained at a level of 6V. Here, the voltage level of 6V should be understood as an example.

As shown in FIG. 30, when driving the drive transistor DTFT in the linear region, the level of the low level voltage EVSS may gradually increase from 0V to 6V. As described above, the level of the low level voltage EVSS changes gradually instead of 0V or 6V in consideration of an image quality problem. The gradual changing method of the level of the low level voltage EVSS is for considering deterioration characteristics and compensation margin of the drive transistor DTFT. Also, since the gradually changed low level voltage EVSS is commonly supplied to all of sub-pixels of a display panel, a global compensation effect can be expected.

When the drive transistor DTFT of the sub-pixel is driven in the linear region, the level of the low level voltage EVSS is maintained or higher than the previous level while the level of the high level voltage EVDD is fixed. Thus, a stress level undergone by the transistor may be reduced compared to a related art method. As a result, the deterioration of the transistor may be expected to be delayed by a longer time period than in the related art method where the drive transistor is driven in the saturation region.

Above all, the third embodiment controls a circuit that generates the low level voltage EVSS, not a circuit that generates the high level voltage EVDD with a relatively high power consumption and a complicated device configuration. Since the circuit for changing the high level voltage has a large number of components for implementing this, and variability of the variable voltage may be large and unstable when the voltage is changed, there is a variety of burdens in the circuit for changing the high level voltage. On the other hand, the circuit for changing the low level voltage is less burdensome than the circuit for changing the high level voltage because of fewer components and less variability or instability of the variable voltage when the voltage is changed. Therefore, the third embodiment can further reduce the power consumption as compared with the second embodiment, and facilitate the configuration and implementation of the circuit.

In addition, since the third embodiment changes the low level voltage, it is possible to design a power supply capable of outputting and changing the voltage by only one converter, thereby having excellent economical efficiency (reduction in manufacturing cost). Since the third embodiment changes the low level voltage that is not a high power consumption voltage such as the high level voltage, it can be expected to achieve high stability and high power consumption efficiency compared with the method of changing the high level voltage.

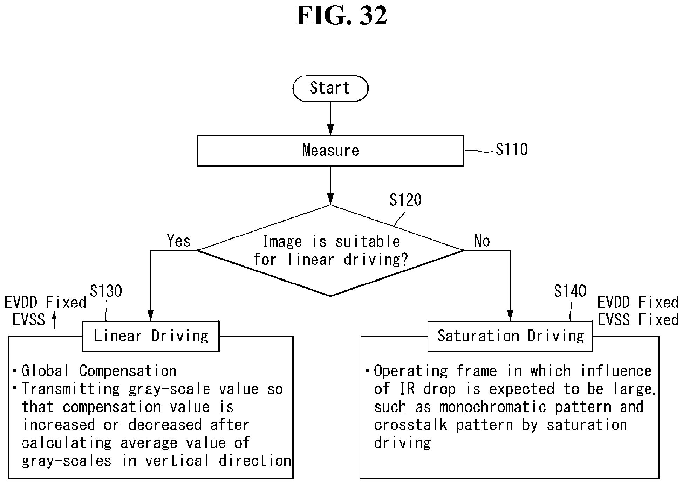

FIG. 31 is a view for explaining a method for determining whether an image quality problem has occurred when driving a drive transistor in a linear region. FIG.32 is a flowchart for explaining a selection scheme of linear driving and saturation driving in accordance with a third embodiment of the present invention.

As shown in FIG. 31, when an image is displayed on a display panel 110, there is a pattern that causes a luminance deviation due to an influence of an IR drop (a voltage drop due to current and resistance). The pattern occurs when there is a vertical line where a deviation of a data voltage is large. Generally, when a black box on a white background is displayed on the display panel 110, a crosstalk which is an image quality problem due to the deviation of the data voltage occurs.

When an image capable of causing the image quality problem is displayed on the display panel 110, if a driving transistor is driven in a linear region, an image quality is lowered further (see the display panel of FIG. 31 (a) and the display panel of FIG. 31(b)).

In order to solve this problem, it is necessary to determine whether an input image data causes the image quality problem based on an image analysis algorithm. A confidence measure for determining presence or absence of an image having a large influence by the IR drop will be described as follows.

First, a gray threshold value Gth should be set so that a portion where a data transition of an input data voltage shows a large width can be filtered. For example, the gray threshold value can be algorithmized to detect a portion where the gray difference appears larger than the gray threshold value Gth.

When the gray threshold value Gth is set to Gth = 200 as shown in FIG. 31, moving from the white background 255 to the black box 3, the difference between these values appears as "255-3> Gth = 200". Therefore, this image is determined to be an image which is expected to cause the crosstalk, which is the image quality problem due to the deviation of the data voltage.

It is determined whether the image is a suitable image for linear driving or a suitable image for saturation driving based on a result of counting whether the number of patterns corresponding to the image causing the crosstalk in one frame as described above is greater than or less than a preset line or an area threshold (N Line / Area Threshold; Nth and N is a natural number). At this time, an image in which the linear driving is not suitable is switched to the saturation driving depending on the result of the final determination.

As shown in FIG. 32, in a method of driving an organic light emitting display device in accordance with the third embodiment, an input image is measured in order to extract a frame having a large influence of an IR drop (S110). The method of measuring the input image may be based on an algorithm by setting a threshold value as shown in FIG. 31, but the present invention is not limited thereto.

After the input image is measured, it is determined whether the image is suitable for the linear driving or the saturation driving (S120). The method of determining the suitable image for the linear driving or the suitable image for the saturation driving may be performed by setting the threshold value as described with reference to FIG. 31 and algorithmizing it, but the present invention is not limited thereto.

In the linear driving method, a low level voltage EVSS is changed in a state where a high level voltage EVDD is fixed (S130). The linear driving scheme has a global compensation effect. After calculating an average value of gray-scales in a vertical direction, a gray-scale value can be transmitted so that a compensation value is increased or decreased based on the average value.

In the saturation driving scheme, the high level voltage EVDD and the low level voltage EVSS are fixed (S140). The saturation driving scheme is limited to a frame in which the influence of the IR drop is expected to be large, such as a monochromatic pattern and a crosstalk pattern.

As in the third embodiment, when the display panel is driven by dividing a display area into the linear region and the saturation region by frame depending on characteristics of an image, it is possible to avoid image quality problems such as deviation in vertical luminance and crosstalk due to the IR drop, as well as reduction in power consumption.

As in the third embodiment, in order to switch selectively the driving scheme of the drive transistor based on whether such an image quality problem occurs for a certain image data, and change a level of the low level voltage EVSS gradually, the present device may be configured as follows:

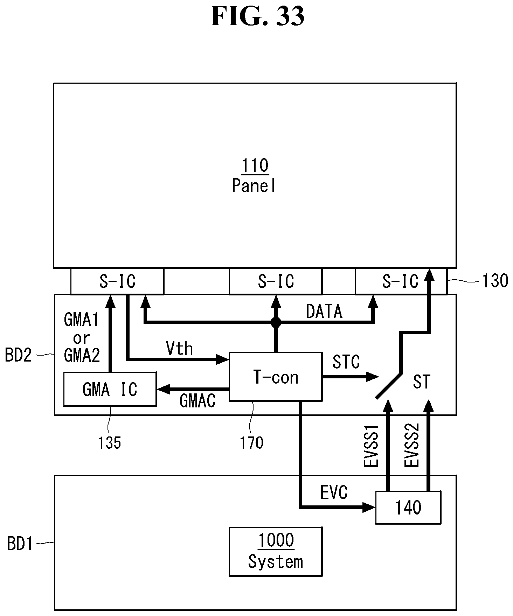

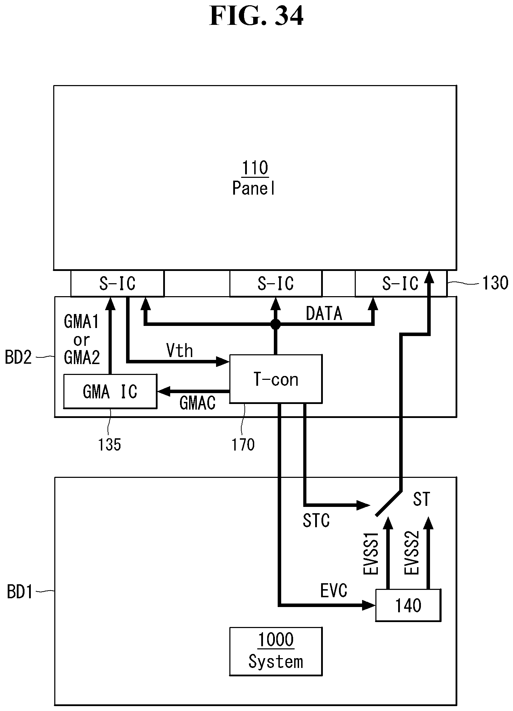

FIG. 33 shows a modular configuration in accordance with a fifth example of the present invention. FIG. 34 shows a modular configuration in accordance with a sixth example of the present invention.

As shown in FIG. 33 illustrating a fifth example modular configuration of an organic light-emitting display device, the organic light-emitting display device may be modularized with a first circuit board BD1, a second circuit board BD2 and a display panel 110. The first circuit board BD1 may include a host system 1000 and a power supply 140 disposed thereon. The second circuit board BD2 may include a timing controller 170, a gamma circuit 135, and a voltage switching circuit ST disposed thereon. The voltage switching circuit ST may be disposed inside or outside the power supply 140. The gamma circuit 135 also performs the same functions or operations as those shown in the first example or the second example. However, since this is not principal features of the third embodiment, the descriptions thereof may be discussed with reference to the portion of the first example or the second example of the present invention.

As shown in FIG. 34 illustrating a sixth example modular configuration of the organic light-emitting display device, the organic light-emitting display device may be modularized with a first circuit board BD1, a second circuit board BD2 and a display panel 110. The first circuit board BD1 may include a host system 1000, a power supply 140 and a voltage switching circuit ST disposed thereon. The second circuit board BD2 may include a timing controller 170 and a gamma circuit 135 disposed thereon. The voltage switching circuit ST may be disposed inside or outside the power supply 140. The gamma circuit 135 also performs the same functions or operations as those shown in the first example or the second example. However, since this is not principal features of the third embodiment, the descriptions thereof may be discussed with reference to the portion of the first example or the second example of the present invention.

The timing controller 170 may be configured to output a switch control signal STC to selectively supply a first high level voltage EVDD1 or a second high level voltage EVDD2 from the power supply 140 disposed on the first circuit board BD1. In one example, the first high level voltage EVDD1 (a saturation region drive voltage) may be higher than the second high level voltage EVDD2 (a linear region drive voltage).

The timing controller 170 may be configured to generate a first switch control signal at the same time when a first drive control signal is generated by a non-linear driver disposed therein, wherein the first drive control signal enables driving for a drive transistor in a saturation region, that is, a normal driving condition.

When the timing controller 170 has outputted the first drive control signal and first switch control signal, the voltage switching circuit ST may be configured to operate such that the first high level voltage EVDD1 from the power supply 140 is supplied to the display panel 110. In this way, the display panel 110 may operate based on an operation condition of the saturation region.

The timing controller 170 may be configured to generate a second switch control signal at the same time when a second drive control signal is generated by a linear driver disposed therein, wherein the second drive control signal enables driving for the drive transistor in a linear region, that is, a change driving condition.

Further, the timing controller 170 monitors or senses deterioration characteristic of the drive transistor, for example, Vth continuously, and generates a power variable signal EVC to increase a level of a low level voltage EVSS gradually based on the deterioration characteristic of the drive transistor, for example, Vth. At this time, the timing controller 170 performs compensation operations to avoid an increase in a data voltage V_{DATA} and gradually increase the level of the level voltage EVSS, when the deterioration characteristic of the drive transistor, for example, Vth, deviates from a reference range (a reference threshold voltage) set inside the timing controller 170.

When the timing controller 170 has outputted the second drive control signal and second switch control signal, the voltage switching circuit ST may be configured to operate such that the second high level voltage EVDD2 from the power supply 140 is supplied to the display panel 110. In this way, the display panel 110 may operate based on an operation condition of the linear region. When the timing controller 170 has outputted the power variable signal EVC, the power supply 140 changes a level of the second high level voltage EVDD2 based on the compensation operations by the timing controller 170 and outputs the level.

The present invention can reduce power consumption by the display device via the changing method of the high level voltage based on the selective driving of the drive transistor of the sub-pixel in the saturation and linear regions. Further, the present invention can suppress deterioration in the display image quality caused by a change in the driving scheme by taking into account the presence or absence of an anticipated image quality deterioration occurrence in selectively driving the drive transistor of the sub-pixel in the saturation and linear regions. Further, the present invention can delay deterioration in the drive transistor by selectively driving the drive transistor of the sub-pixel in the saturation and linear regions. Further, when driving the driving transistor in the linear region, there is an effect that the life time of the product can be improved by gradually changing the high level voltage depending on the change of the threshold voltage. Furthermore, when driving the drive transistor in the linear region, there is an effect that the power consumption can be reduced by gradually changing the low level voltage depending on the change of the threshold voltage.

Although embodiments have been described with reference to a number of illustrative embodiments thereof, it should be understood that numerous other modifications and embodiments can be devised by those skilled in the art that will fall within the scope of the appended claims.

## Claims

1. An organic light-emitting display device comprising:
a display panel (110) including a plurality of sub-pixels, wherein each sub-pixel of the plurality of sub-pixels includes a drive transistor;
a power supply (140) configured to output a voltage for driving the sub-pixels;
a selective driver (160) configured to generate a first control signal when low and middle gray-scale ranges are expressed on the display panel to enable selective driving of the respective drive transistor of a sub-pixel of the plurality of sub-pixels in a first driving scheme, or to generate a second control signal when a high gray-scale range is expressed on the display panel to enable selective driving of the respective drive transistor in a second driving scheme,
wherein the respective drive transistor is driven in a saturation region in the first driving scheme, and is driven in a linear region in the second driving scheme; and **characterized by**
a gamma change driver (165) configured to change a gamma based on the driving scheme selected by the selective driver, wherein in the first driving scheme the gamma change driver is configured to change the gamma to a linear gamma, and wherein in the second driving scheme the gamma change driver is configured to change the gamma to a non-linear gamma;
a timing controller (170) configured to output a data signal; and
a data driver (130) configured to convert the data signal output from the timing controller into a data voltage based on the gamma changed according to the selected driving scheme and to supply the data voltage to the display panel (110).

2. The device of claim 1, wherein the power supply (140) is configured to:
supply a first level voltage to the display panel (110) when the drive transistor of the sub-pixels is driven in the saturation region; and
supply a second level voltage to the display panel (110) when the drive transistor of the sub-pixels is driven in the linear region, wherein the second level voltage is lower than the first level voltage.

3. The device of claim 1 or 2, wherein the selective driver (160) is configured to change an operating condition of the drive transistor from the linear region to the saturation region based on a result of an analysis of image data which is to be supplied to the display panel.

4. The device of any preceding claim, wherein the selective driver (160) is configured to change an operating condition of the drive transistor from the linear region to the saturation region when image data to be supplied to the display panel (110) has a parameter value smaller than a predetermined threshold value.

5. The device of any preceding claim, wherein the selective driver (160) includes:
a normal driver (161) configured to generate a control signal for driving the drive transistor of the sub-pixels in the saturation region;
a linear driver (163) configured to generate a control signal for driving the drive transistor of the sub-pixels in the linear region; and
a compensation module (180) configured to compensate for variation of the display panel (110) resulting from the selective driving between the first and second driving schemes.

6. The device of claim 2, wherein the power supply (140) includes a voltage switching circuit configured to perform a switching operation to supply one of the first level voltage and the second level voltage to the display panel (110), and/or
optionally wherein the first level voltage is higher than a data voltage to be supplied to the display panel, and the second level voltage is lower than the data voltage, and/or
optionally wherein the second level voltage is changed gradually in response to changes in a threshold voltage of the drive transistor, and/or
optionally further comprising a timing controller (170) configured to:
monitor a threshold voltage of the drive transistor;
generate a power variable signal to increase a level of the second level voltage gradually in response to changes in the threshold voltage of the drive transistor; and
output the power variable signal to the power supply (140).

7. The device of any preceding claim, wherein the power supply (140) is configured to:
change a high level voltage while a low level voltage is fixed; or
change the low level voltage while the high level voltage is fixed.

8. The device of any preceding claim, further comprising:
a compensation circuit (180) configured to analyze a data signal to be supplied to the display panel (110), and to compensate the data signal to compensate and improve variation of the display panel (110) resulting from the selective driving between the first and the second driving schemes.

9. The device of claim 8 when dependent on claim 7, wherein the timing controller (170) includes the selective driver (160) and the compensation circuit (180), and
wherein the power supply (140) is configured to change a level of the low level voltage based on a compensation operation of the data signal by the timing controller.

10. The device of claim 9, further comprising:
a first circuit board on which the power supply (140) is disposed,
a second circuit board on which the timing controller (170) is disposed,
a voltage switching circuit which is disposed on the first circuit board or the second circuit board and configured to perform a switching operation so that one of the high level voltage and the low level voltage outputted from the power supply is supplied to the display panel (110) based on a control signal outputted from the timing controller (170),
optionally wherein the voltage switching circuit is configured to:
perform a switching operation so that the high level voltage is supplied to the display panel (110) when a first signal is outputted from the timing controller; and
perform a switching operation so that the low level voltage is supplied to the display panel (110) when a second signal is outputted from the timing controller.

11. A method of driving an organic light-emitting display device according to claims 1 to 10, the method comprising:
generating a first control signal when low and middle gray-scale ranges are expressed on a display panel of the display device to enable selective driving of a drive transistor of sub-pixels in a first driving scheme, or
generating a second control signal when a high gray-scale range is expressed on the display panel of the display device to enable selective driving of the drive transistor in a second driving scheme,
wherein the drive transistor is driven in a saturation region in the first driving scheme, and is driven in a linear region in the second driving scheme; the method **characterized by**
generating a signal to change a gamma based on the selected driving scheme, wherein in the first driving scheme the signal is configured to change the gamma to a linear gamma, and wherein in the second driving scheme the signal is configured to change the gamma to a non-linear gamma;
converting the data signal into a data voltage based on the gamma changed according to the selected driving scheme; and
supplying the data voltage to the display panel.

12. The method of claim 11, wherein the changing of the level of the voltage further includes increasing a level of the second level voltage gradually in response to changes in a threshold voltage of the drive transistor when the drive transistor is driven in the linear region.

13. The method of claim 11, wherein the changing of the level of the voltage includes changing a high level voltage while a low level voltage is fixed, or changing the low level voltage while the high level voltage is fixed.

14. The method of claim 11, further comprising:
changing a level of a voltage to be supplied to the sub-pixels based on the selected driving scheme,
wherein the changing of the level of the voltage includes:
selecting a first level voltage when the drive transistor is driven in the saturation region; and
selecting a second level voltage when the drive transistor is driven in the linear region, wherein the second level voltage is lower than the first level voltage.

## Patentansprüche

1. Organische Lichtemissionsanzeigevorrichtung, die Folgendes umfasst:
ein Anzeigefeld (110), das mehrere Subpixel beinhaltet, wobei jedes Subpixel der mehreren Subpixel einen Ansteuerungstransistor beinhaltet;
eine Leistungsversorgung (140), die zum Ausgeben einer Spannung zum Ansteuern der Subpixel ausgebildet ist;
eine selektive Ansteuerung (160), die zum Erzeugen eines ersten Steuersignals, wenn untere und mittlere Graustufenbereiche auf dem Anzeigefeld ausgedrückt werden, um eine selektive Ansteuerung des jeweiligen Ansteuerungstransistors eines Subpixels der mehreren Subpixel in einem ersten Ansteuerungsschema zu ermöglichen, oder zum Erzeugen eines zweiten Steuersignals, wenn ein hoher Graustufenbereich auf dem Anzeigefeld ausgedrückt wird, um eine selektive Ansteuerung des jeweiligen Ansteuerungstransistors in einem zweiten Ansteuerungsschema zu ermöglichen, ausgebildet ist,
wobei der jeweilige Ansteuerungstransistor in einem Sättigungsgebiet in dem ersten Ansteuerungsschema angesteuert wird und in einem linearen Gebiet in dem zweiten Ansteuerungsschema angesteuert wird; und
**gekennzeichnet durch**
eine Gammawertänderungsansteuerung (165), die zum Ändern eines Gammawertes basierend auf dem durch die selektive Ansteuerung ausgewählten Ansteuerungsschema ausgebildet ist, wobei in dem ersten Ansteuerungsschema die Gammawertänderungsansteuerung zum Ändern des Gammawertes auf einen linearen Gammawert ausgebildet ist und wobei in dem zweiten Ansteuerungsschema die Gammawertänderungsansteuerung zum Ändern des Gammawertes auf einen nichtlinearen Gammawert ausgebildet ist;
eine Timingsteuerung (170), die zum Ausgeben eines Datensignals ausgebildet ist; und
eine Datenansteuerung (130), die zum Umwandeln des Datensignals, das von der Timingsteuerung ausgegeben wird, in eine Datenspannung basierend auf dem Gammawert, der gemäß dem ausgewählten Ansteuerungsschema geändert wird, und zum Liefern der Datenspannung an das Anzeigefeld (110) ausgebildet ist.

2. Vorrichtung nach Anspruch 1, wobei die Leistungsversorgung (140) zu Folgendem konfiguriert ist:
Liefern einer Spannung mit einem ersten Pegel an das Anzeigefeld (110), wenn der Ansteuerungstransistor der Subpixel in dem Sättigungsgebiet angesteuert wird; und
Liefern einer Spannung mit einem zweiten Pegel an das Anzeigefeld (110), wenn der Ansteuerungstransistor der Subpixel in dem linearen Gebiet angesteuert wird, wobei die Spannung mit dem zweiten Pegel niedriger als die Spannung mit dem ersten Pegel ist.

3. Vorrichtung nach Anspruch 1 oder 2, wobei die selektive Ansteuerung (160) zum Ändern eines Betriebszustands des Ansteuerungstransistors von dem linearen Gebiet zu dem Sättigungsgebiet basierend auf einem Ergebnis einer Analyse von Bilddaten, die an das Anzeigefeld geliefert werden, ausgebildet ist.

4. Vorrichtung nach einem vorhergehenden Anspruch, wobei die selektive Ansteuerung (160) zum Ändern eines Betriebszustands des Ansteuerungstransistors von dem linearen Gebiet zu dem Sättigungsgebiet ausgebildet ist, wenn Bilddaten, die an das Anzeigefeld (110) zu liefern sind, einen Parameterwert kleiner als ein vorbestimmter Schwellenwert aufweisen.

5. Vorrichtung nach einem vorhergehenden Anspruch, wobei die selektive Ansteuerung (160) Folgendes beinhaltet:
eine Normalansteuerung (161), die zum Erzeugen eines Steuersignals zum Ansteuern des Ansteuerungstransistors der Subpixel in dem Sättigungsgebiet ausgebildet ist;
eine Linearansteuerung (163), die zum Erzeugen eines Steuersignals zum Ansteuern des Ansteuerungstransistors der Subpixel in dem linearen Gebiet ausgebildet ist; und
ein Kompensationsmodul (180), das zum Kompensieren einer Variation des Anzeigefelds (110) konfiguriert ist, die aus der selektiven Ansteuerung zwischen dem ersten und zweiten Ansteuerungsschema resultiert.

6. Vorrichtung nach Anspruch 2,
wobei die Leistungsversorgung (140) einen Spannungsschalt-Schaltkreis beinhaltet, der zum Durchführen einer Schaltoperation ausgebildet ist, um die Spannung mit dem ersten Pegel oder die Spannung mit dem zweiten Pegel an das Anzeigefeld (110) zu liefern, und/oder
wobei optional die Spannung mit dem ersten Pegel höher als eine Datenspannung ist, die an das Anzeigefeld zu liefern ist, und die Spannung mit dem zweiten Pegel niedriger als die Datenspannung ist, und/oder
wobei optional die Spannung mit dem zweiten Pegel als Reaktion auf Änderungen einer Schwellenspannung des Ansteuerungstransistors graduell geändert wird, und/oder
die optional ferner eine Timingsteuerung (170) umfasst, die zu Folgendem ausgebildet ist:
Überwachen einer Schwellenspannung des Ansteuerungstransistors;
Erzeugen eines variablen Leistungssignals, um einen Pegel der Spannung mit dem zweiten Pegel graduell als Reaktion auf Änderungen der Schwellenspannung des Ansteuerungstransistors zu erhöhen; und
Ausgeben des variablen Leistungssignals an die Leistungsversorgung (140).

7. Vorrichtung nach einem vorhergehenden Anspruch, wobei die Leistungsversorgung (140) zu Folgendem ausgebildet ist:
Ändern einer Spannung mit hohem Pegel, während eine Spannung mit niedrigem Pegel fest ist; oder
Ändern der Spannung mit niedrigem Pegel, während die Spannung mit hohem Pegel fest ist.

8. Vorrichtung nach einem vorhergehenden Anspruch, die ferner Folgendes umfasst:
einen Kompensationsschaltkreis (180), der zum Analysieren eines Datensignals, das an das Anzeigefeld (110) zu liefern ist, und zum Kompensieren des Datensignals, um eine Variation des Anzeigefelds (110) zu kompensieren und zu verbessern, die aus dem selektiven Ansteuern zwischen dem ersten und dem zweiten Ansteuerungsschema resultiert, ausgebildet ist.

9. Vorrichtung nach Anspruch 8, wenn abhängig von Anspruch 7, wobei die Timingsteuerung (170) die selektive Ansteuerung (160) und den Kompensationsschaltkreis (180) beinhaltet, und
wobei die Leistungsversorgung (140) zum Ändern eines Pegels der Spannung mit niedrigem Pegel basierend auf einer Kompensationsoperation des Datensignals durch die Timingsteuerung ausgebildet ist.

10. Vorrichtung nach Anspruch 9, die ferner Folgendes umfasst:
eine erste Leiterplatte, auf der die Leistungsversorgung (140) angeordnet ist,
eine zweite Leiterplatte, auf der die Timingsteuerung (170) angeordnet ist,
einen Spannungsschalt-Schaltkreis, der auf der ersten Leiterplatte oder der zweiten Leiterplatte angeordnet ist und zum Durchführen einer Schaltoperation derart,
dass die Spannung mit hohem Pegel oder die Spannung mit niedrigem Pegel, die von der Leistungsversorgung ausgegeben wird, an das Anzeigefeld (110) geliefert wird, basierend auf einem Steuersignal, das von der Timingsteuerung (170) ausgegeben wird, ausgebildet ist,
wobei optional der Spannungsschalt-Schaltkreis zu Folgendem ausgebildet ist:
Durchführen einer Schaltoperation derart, dass die Spannung mit dem hohen Pegel an das Anzeigefeld (110) geliefert wird, wenn ein erstes Signal von der Timingsteuerung ausgegeben wird; und
Durchführen einer Schaltoperation derart, dass die Spannung mit niedrigem Pegel an das Anzeigefeld (110) geliefert wird, wenn ein zweites Signal von der Timingsteuerung ausgegeben wird.

11. Verfahren zum Ansteuern einer organischen Lichtemissionsanzeigevorrichtung nach Ansprüchen 1 bis 10, wobei das Verfahren Folgendes umfasst:
Erzeugen eines ersten Steuersignals, wenn untere und mittlere Graustufenbereiche auf einem Anzeigefeld der Anzeigevorrichtung ausgedrückt werden, um eine selektive Ansteuerung eines Ansteuerungstransistors von Subpixeln in einem ersten Ansteuerungsschema zu ermöglichen, oder
Erzeugen eines zweiten Steuersignals, wenn ein hoher Graustufenbereich auf dem Anzeigefeld der Anzeigevorrichtung ausgedrückt wird, um eine selektive Ansteuerung des Ansteuerungstransistors in einem zweiten Ansteuerungsschema zu ermöglichen,
wobei der Ansteuerungstransistor in einem Sättigungsgebiet in dem ersten Ansteuerungsschema angesteuert wird und in einem linearen Gebiet in dem zweiten Ansteuerungsschema angesteuert wird; wobei das Verfahren **gekennzeichnet ist durch**
Erzeugen eines Signals zum Ändern eines Gammawertes basierend auf dem ausgewählten Ansteuerungsschema, wobei in dem ersten Ansteuerungsschema das Signal zum Ändern des Gammawertes auf einen linearen Gammawert ausgebildet ist und wobei in dem zweiten Ansteuerungsschema das Signal zum Ändern des Gammawertes auf einen nichtlinearen Gammawert ausgebildet ist;
Umwandeln des Datensignals in eine Datenspannung basierend auf dem Gammawert, der gemäß dem ausgewählten Ansteuerungsschema geändert wird; und
Liefern der Datenspannung an das Anzeigefeld.

12. Verfahren nach Anspruch 11, wobei das Ändern des Pegels der Spannung ferner Erhöhen eines Pegels der Spannung mit dem zweiten Pegel graduell als Reaktion auf Änderungen einer Schwellenspannung des Ansteuerungstransistors, wenn der Ansteuerungstransistor in dem linearen Gebiet angesteuert wird, beinhaltet.

13. Verfahren nach Anspruch 11, wobei das Ändern des Pegels der Spannung Ändern einer Spannung mit hohem Pegel, während eine Spannung mit niedrigem Pegel fest ist, oder Ändern der Spannung mit niedrigem Pegel, während die Spannung mit hohem Pegel fest ist, beinhaltet.

14. Verfahren nach Anspruch 11, das ferner Folgendes umfasst:
Ändern eines Pegels einer Spannung, die an die Subpixel zu liefern ist, basierend auf dem Ansteuerungsschema,
wobei das Ändern des Pegels der Spannung Folgendes beinhaltet:
Auswählen einer Spannung mit einem ersten Pegel, wenn der Ansteuerungstransistor in dem Sättigungsgebiet angesteuert wird; und
Auswählen einer Spannung mit einem zweiten Pegel, wenn der Ansteuerungstransistor in dem linearen Gebiet angesteuert wird, wobei die Spannung mit dem zweiten Pegel niedriger als die Spannung mit dem ersten Pegel ist.

## Revendications

1. Dispositif d'affichage électroluminescent organique comprenant :
un panneau d'affichage (110) comprenant une pluralité de sous-pixels, dans lequel chaque sous-pixel de la pluralité de sous-pixels comprend un transistor d'attaque ;
une alimentation électrique (140) configurée pour sortir une tension pour entraîner les sous-pixels ;
un circuit de pilotage sélectif (160) configuré pour générer un premier signal de commande lorsque des plages d'échelle de gris faible et intermédiaire sont exprimées sur le panneau d'affichage pour permettre un pilotage sélectif du transistor d'attaque respectif d'un sous-pixel de la pluralité de sous-pixels dans un premier schéma de pilotage, ou pour générer un second signal de commande lorsqu'une plage d'échelle de gris élevée est exprimée sur le panneau d'affichage pour permettre un pilotage sélectif du transistor d'attaque respectif dans un second schéma de pilotage,
dans lequel le transistor d'attaque respectif est piloté dans une région de saturation dans le premier schéma de pilotage et est piloté dans une région linéaire dans le second schéma de pilotage ; et
**caractérisé par**
un circuit de pilotage de changement de gamma (165) configuré pour changer un gamma en se basant sur le schéma de pilotage sélectionné par le circuit de pilotage sélectif, dans lequel, dans le premier schéma de pilotage, le circuit de pilotage de changement de gamma est configuré pour passer le gamma à un gamma linéaire, et dans lequel, dans le second schéma de pilotage, le circuit de pilotage de changement de gamma est configuré pour passer le gamma à un gamma non linéaire ;
un dispositif de commande de synchronisation (170) configuré pour émettre un signal de données ; et
un circuit de pilotage de données (130) configuré pour convertir le signal de données émis depuis le dispositif de commande de synchronisation en une tension de données en se basant sur le gamma changé en fonction du schéma de pilotage sélectionné et pour fournir la tension de données au panneau d'affichage (110).

2. Dispositif selon la revendication 1, dans lequel l'alimentation électrique (140) est configurée :
pour fournir une tension de premier niveau au panneau d'affichage (110) lorsque le transistor d'attaque des sous-pixels est piloté dans la région de saturation ; et
pour fournir une tension de second niveau au panneau d'affichage (110) lorsque le transistor d'attaque des sous-pixels est piloté dans la région linéaire, dans lequel la tension de second niveau est inférieure à la tension de premier niveau.

3. Dispositif selon la revendication 1 ou 2, dans lequel le circuit de pilotage sélectif (160) est configuré pour passer un état de fonctionnement du transistor d'attaque de la région linéaire à la région de saturation en se basant sur un résultat d'une analyse de données d'image qui doivent être fournies au panneau d'affichage.

4. Dispositif selon l'une quelconque des revendications précédentes, dans lequel le circuit de pilotage sélectif (160) est configuré pour passer un état de fonctionnement du transistor d'attaque de la région linéaire à la région de saturation lorsque des données d'image qui doivent être fournies au panneau d'affichage (110), présentent une valeur de paramètre inférieure à une valeur de seuil prédéterminée.

5. Dispositif selon l'une quelconque des revendications précédentes, dans lequel le circuit de pilotage sélectif (160) comprend :
un circuit de pilotage normal (161) configuré pour générer un signal de commande pour piloter le transistor d'attaque des sous-pixels dans la région de saturation ;
un circuit de pilotage linéaire (163) configuré pour générer un signal de commande pour piloter le transistor d'attaque des sous-pixels dans la région linéaire ; et
un module de compensation (180) configuré pour compenser une variation du panneau d'affichage (110) résultant du pilotage sélectif entre le premier et le second schéma de pilotage.

6. Dispositif selon la revendication 2,
dans lequel l'alimentation électrique (140) comprend un circuit de commutation de tension configuré pour effectuer une opération de commutation pour fournir soit la tension de premier niveau, soit la tension de second niveau au panneau d'affichage (110) et/ou
facultativement, dans lequel la tension de premier niveau est plus élevée qu'une tension de données qui doit être fournie au panneau d'affichage et la tension de second niveau est plus basse que la tension de données et/ou
facultativement, dans lequel la tension de second niveau est modifiée petit à petit à la suite de changements d'une tension de seuil du transistor d'attaque et/ou
facultativement comprenant en outre un dispositif de commande de synchronisation (170) configuré :
pour surveiller une tension de seuil du transistor d'attaque ;
pour générer un signal à puissance variable pour augmenter un niveau de la tension de second niveau petit à petit à la suite de changements de la tension de seuil du transistor d'attaque ; et
pour émettre le signal à puissance variable vers l'alimentation électrique (140).

7. Dispositif selon l'une quelconque des revendications précédentes, dans lequel l'alimentation électrique (140) est configurée :
pour changer une tension de niveau élevé pendant qu'une tension de bas niveau est fixe ; ou
pour changer la tension de bas niveau pendant que la tension de niveau élevé est fixe.

8. Dispositif selon l'une quelconque des revendications précédentes, comprenant en outre :
un circuit de compensation (180) configuré pour analyser un signal de données qui doit être fourni au panneau d'affichage (110), et pour compenser le signal de données pour compenser et améliorer une variation du panneau d'affichage (110) résultant du pilotage sélectif entre le premier et le second schéma de pilotage.

9. Dispositif selon la revendication 8 lorsqu'elle dépend de la revendication 7, dans lequel le dispositif de commande de synchronisation (170) comprend le circuit de pilotage sélectif (160) et le circuit de compensation (180) et
dans lequel l'alimentation électrique (140) est configurée pour changer un niveau de la tension de bas niveau en se basant sur une opération de compensation du signal de données par le dispositif de commande de synchronisation.

10. Dispositif selon la revendication 9, comprenant en outre :
une première carte de circuit imprimé sur laquelle l'alimentation électrique (140) est disposée,
une seconde carte de circuit imprimé sur laquelle le dispositif de commande de synchronisation (170) est disposé,
un circuit de commutation de tension qui est disposé sur la première carte de circuit imprimé ou sur la seconde carte de circuit imprimé et configuré pour effectuer une opération de commutation de telle sorte que soit la tension de niveau élevé, soit la tension de bas niveau émise depuis l'alimentation électrique soit fournie au panneau d'affichage (110) en se basant sur un signal de commande émis depuis le dispositif de commande de synchronisation (170),
facultativement dans lequel le circuit de commutation de tension est configuré :
pour effectuer une opération de commutation de telle sorte que la tension de niveau élevé soit fournie au panneau d'affichage (110) lorsqu'un premier signal est émis depuis le dispositif de commande de synchronisation ; et
pour effectuer une opération de commutation de telle sorte que la tension de bas niveau soit fournie au panneau d'affichage (110) lorsqu'un second signal est émis depuis le dispositif de commande de synchronisation.

11. Procédé de pilotage d'un dispositif d'affichage électroluminescent organique selon les revendications 1 à 10, le procédé consistant :
à générer un premier signal de commande lorsque des plages d'échelle de gris faible et intermédiaire sont exprimées sur un panneau d'affichage du dispositif d'affichage pour permettre un pilotage sélectif d'un transistor d'attaque de sous-pixels dans un premier schéma de pilotage, ou
à générer un second signal de commande lorsqu'une plage d'échelle de gris élevée est exprimée sur le panneau d'affichage du dispositif d'affichage pour permettre un pilotage sélectif du transistor d'attaque dans un second schéma de pilotage,
dans lequel le transistor d'attaque est piloté dans une région de saturation dans le premier schéma de pilotage et est piloté dans une région linéaire dans le second schéma de pilotage ; le procédé étant **caractérisé en ce qu'**il consiste
à générer un signal pour changer un gamma en se basant sur le schéma de pilotage sélectionné, dans lequel, dans le premier schéma de pilotage, le signal est configuré pour passer le gamma à un gamma linéaire, et dans lequel, dans le second schéma de pilotage, le signal est configuré pour passer le gamma à un gamma non linéaire ;
à convertir le signal de données en une tension de données en se basant sur le gamma changé en fonction du schéma de pilotage sélectionné ; et
à fournir la tension de données au panneau d'affichage.

12. Procédé selon la revendication 11, dans lequel le changement du niveau de la tension consiste en outre à augmenter un niveau de la tension de second niveau petit à petit à la suite de changements d'une tension de seuil du transistor d'attaque lorsque le transistor d'attaque est piloté dans la région linéaire.

13. Procédé selon la revendication 11, dans lequel le changement du niveau de la tension consiste à changer une tension de niveau élevé pendant qu'une tension de bas niveau est fixe, ou à changer la tension de bas niveau pendant que la tension de niveau élevé est fixe.

14. Procédé selon la revendication 11, consistant en outre :
à changer un niveau d'une tension qui doit être fournie aux sous-pixels en se basant sur le schéma de pilotage sélectionné,
dans lequel le changement du niveau de la tension consiste :
à sélectionner une tension de premier niveau lorsque le transistor d'attaque est piloté dans la région de saturation ; et
à sélectionner une tension de second niveau lorsque le transistor d'attaque est piloté dans la région linéaire, dans lequel la tension de second niveau est inférieure à la tension de premier niveau.
